# EUROPÄISCHE PATENTSCHRIFT

(11) **EP 3 447 855 B1**
(45) Veröffentlichungstag und Bekanntmachung des Hinweises auf die Patenterteilung: **03.02.2021**
(21) Anmeldenummer: 18190407.9
(22) Anmeldetag: 23.08.2018
(51) Int. Cl.: H01R 13/6587, H01R 13/518, H01R 12/72, H05K 1/11, H05K 1/02, H01R 12/70

(54) **VERBINDERSYSTEM UND VERBINDERELEMENT ZUM VERBINDEN EINER PCB-KARTE MIT EINEM KFZ-ZENTRALRECHNER**
CONNECTOR SYSTEM AND CONNECTOR ELEMENT FOR CONNECTING A PCB CARD WITH A MOTOR VEHICLE CENTRAL COMPUTER
SYSTÈME DE RACCORD ET ÉLÉMENT DE RACCORD DESTINÉS À RACCORDER UNE CARTE DE CIRCUIT IMPRIMÉ À UN ORDINATEUR CENTRAL DE VÉHICULE AUTOMOBILE

(30) Priorität: 25.08.2017 DE 102017008065; 25.08.2017 DE 102017008087
(43) Veröffentlichungstag der Anmeldung: 27.02.2019
(73) Patentinhaber: Yamaichi Electronics Deutschland GmbH, 85609 Aschheim-Dornach (DE)
(72) Erfinder: QUITER, Michael, 57482 Wenden (DE); SERRANO, Jaime Fernández, 80796 München (DE); MICHEL, Dirk, 85778 Haimhausen (DE)
(74) Vertreter: Müller-Boré & Partner Patentanwälte PartG mbB

(56) Entgegenhaltungen:
- EP-A1- 2 194 610

## Beschreibung

Die Erfindung betrifft ein rechnerseitiges und kartenseitiges Verbinderelement für ein Verbindersystem zum Verbinden einer PCB-Karte mit einem Zentralrechner eines Kraftfahrzeugs.

Moderne Kraftfahrzeuge werden mit einem Zentralrechner ausgestattet, der diverse Automotive Anwendungen ausführen bzw. steuern kann. Dazu kann der Zentralrechner des Kraftfahrzeugs wie bei einem Mainboard eines PCs oder Notebooks mit einer PCB (Printed Circuit Board) Karte bzw. einer Chipkarte verbunden werden, die für die jeweilige Anwendung spezifisch ist. Es ist daher erforderlich, ein für den Automotive Bereich geeignetes Verbindersystem zwischen einer PCB-Karte und dem Zentralrechner eines Kraftfahrzeugs bereitzustellen.

Im Stand der Technik existieren Netzwerkstecker bzw. Netzwerkverbinder aus dem Bereich der Telekommunikation, die jedoch nicht für den Automotive Bereich konzipiert bzw. geeignet sind. Weiterhin existieren hochpolige Verbinder, die eine Vielzahl von einzelnen Blechen zur Schirmung der Kontaktelemente aufweisen. Solche Verbinder sind jedoch nicht massentauglich und bereits aus diesem Grund nicht für den Automotive Bereich geeignet. Die Druckschrift EP 2 194 610 A1 offenbart z.B. ein elektrisches Verbindersystem zum Montieren eines Substrats, wobei das Verbindersystem ein Wafer-Gehäuse und mehrere Wafer-Baugruppen umfasst.

Es ist eine Aufgabe der vorliegenden Erfindung, ein rechnerseitiges und ein kartenseitiges Verbinderelement für ein Verbindersystem zum Verbinden einer PCB-Karte mit einem Zentralrechner eines Kraftfahrzeugs bereitzustellen, welches den Anforderungen im Automotive Bereich, insbesondere hinsichtlich Stabilität, Signalgüte und elektromagnetischer Verträglichkeit genügt.

Diese Aufgabe wird durch die unabhängigen Ansprüche 1 und 2 gelöst. Vorteilhafte Ausführungsformen sind Gegenstand der Unteransprüche.

Ein Unteranspruch betrifft ein Verbindersystem zum Verbinden einer PCB-Karte mit einem Zentralrechner eines Kraftfahrzeugs, aufweisend ein erfindungsgemäßes rechnerseitiges Verbinderelement und ein erfindungsgemäßes kartenseitiges Verbinderelement, wobei das rechnerseitige Verbinderelement ein rechnerseitiges Gehäuse und das kartenseitge Verbinderelement ein kartenseitiges Gehäuse aufweist, wobei das rechnerseitige Gehäuse eine Vielzahl von rechnerseitigen Abschirmelementen aufweist, welche vorgesehen und angeordnet sind, um eine Vielzahl von rechnerseitigen Kontakthohlräumen des rechnerseitigen Gehäuses auszubilden, wobei das kartenseitige Gehäuse eine Vielzahl von kartenseitigen Abschirmelementen aufweist, welche ausgelegt und angeordnet sind, um eine Vielzahl von kartenseitigen Kontakthohlräumen des kartenseitigen Gehäuses auszubilden, und wobei die rechnerseitigen Abschirmelemente Endabschnitte aufweisen, welche ausgelegt und angeordnet sind, um im montierten Zustand jeweils mit zugehörigen Endabschnitten der kartenseitigen Abschirmelemente zu überlappen.

Unter einem "rechnerseitigen Verbinderelement" wird ein Verbinderelement verstanden, welches ausgelegt ist, um unmittelbar an einen Zentralrechner angeschlossen zu werden. Entsprechend wird unter einem "kartenseitigen Verbinderelement" ein Verbinderelement verstanden, welches ausgelegt ist, um unmittelbar an eine PCB-Karte angeschlossen zu werden. Allgemein deutet die Zusatzbezeichnung "rechnerseitig" bei verschiedenen Elementen an, dass diese Elemente zu dem rechnerseitigen Verbinderelement gehören. Entsprechend deutet die Zusatzbezeichnung "kartenseitig" bei verschiedenen Elementen an, dass diese Elemente zu dem kartenseitigen Verbinderelement gehören.

Eine PCB-Karte kann z.B. eine PCMCIA Express 3.0 bzw. 4.0 Karte sein. Es versteht sich, dass mit "PCB-Karte" auch sämtliche andere Chipkarten umfasst sind, welche insbesondere für die Verwendung im Automotive Bereich geeignet sind.

Das rechnerseitige Gehäuse weist eine Vielzahl von rechnerseitigen Abschirmelementen auf. Die rechnerseitigen Abschirmelemente sind somit keine separaten Bauteile des rechnerseitigen Verbinderelements, sondern Bestandteil des rechnerseitigen Gehäuses. Mit anderen Worten ist das rechnerseitige Gehäuse derart beschaffen bzw. geformt, dass es eine Vielzahl von rechnerseitigen Abschirmelementen enthält bzw. ausbildet. Die Gesamtheit der rechnerseitigen Abschirmelemente ist aus einem einzigen (Gehäuse)-Stück, d.h. einstückig, ausgebildet. Die rechnerseitigen Abschirmelemente stellen somit keine Einzelteile des rechnerseitigen Verbinderelements dar, sondern werden unmittelbar mit dem rechnerseitigen Gehäuse bereitgestellt.

Entsprechend weist das kartenseitige Gehäuse eine Vielzahl von kartenseitigen Abschirmelementen auf. Die kartenseitigen Abschirmelemente sind somit keine separaten Bauteile des kartenseitigen Verbinderelements, sondern Bestandteil des rechnerseitigen Gehäuses. Mit anderen Worten ist das kartenseitige Gehäuse derart beschaffen bzw. geformt, dass es eine Vielzahl von kartenseitigen Abschirmelementen enthält bzw. ausbildet. Die Gesamtheit der kartenseitigen Abschirmelemente ist aus einem einzigen (Gehäuse)-Stück, d.h. einstückig, ausgebildet. Die kartenseitigen Abschirmelemente stellen somit keine Einzelteile des kartenseitigen Verbinderelements dar, sondern werden unmittelbar mit dem kartenseitigen Gehäuse bereitgestellt.

Unter einem Abschirmelement wird ein Element zum Abschirmen von, insbesondere bei höheren Frequenzen auftretenden, elektrischen, magnetischen und/oder elektromagnetischen Feldern bzw. Störsignalen verstanden. Insbesondere dienen die Abschirmelemente dazu, die Kontaktelemente des erfindungsgemäßen Verbindersystems bzw. der Verbinderelemente von elektrischen und/oder magnetischen Feldern fernzuhalten. Umgekehrt dienen die Abschirmelemente aber auch dazu, die Umgebung von den durch das Verbindersystem bzw. die Verbinderelemente ausgehenden Feldern zu schützen.

Die rechnerseitigen Abschirmelemente sind vorzugsweise rechnerseitige Begrenzungselemente bzw. Wandungen, welche derart angeordnet sind, dass sie rechnerseitige Kontakthohlräume ausbilden. Die rechnerseitigen Kontakthohlräume sind vorzugsweise in Form einer Matrix angeordnet und dienen insbesondere jeweils zur Aufnahme von Differential-Pair Kontaktelementen bzw. Differential-Pair Kontaktelementpaaren. Folglich können diese rechnerseitigen Kontakthohlräume auch als rechnerseitige Differential-Pair Kontakthohlräume bezeichnet werden.

Entsprechend sind die kartenseitigen Abschirmelemente vorzugsweise kartenseitige Begrenzungselemente bzw. Wandungen, welche derart angeordnet sind, dass sie kartenseitige Kontakthohlräume ausbilden. Die kartenseitigen Kontakthohlräume sind insbesondere in Form einer Matrix angeordnet und dienen zur Aufnahme von Differential-Pair Kontaktelementen bzw. Differential-Pair Kontaktelementpaaren. Folglich können diese kartenseitigen Kontakthohlräume auch als kartenseitige Differential-Pair Kontakthohlräume bezeichnet werden.

Differential-Pair Kontaktelemente sind Kontaktelemente, welche für eine symmetrische oder differentielle Signalübertragung, d.h. zum Übertragen von Differenzsignalen, verwendet werden. Eine symmetrische Signalübertragung ist ein Verfahren, um Signale auch bei längeren Übertragungswegen möglichst tolerant gegenüber Störeinstrahlungen übermitteln zu können. Die Übertragung erfolgt dabei statt mit nur einem einzigen Signalleiter mit einem Paar gleichartiger Signalleiter, also mit Hilfe eines Differential-Pair Kontaktelementpaares. Dabei wird auf der einen Leitung das eigentliche Signal und auf der anderen Leitung ein dem Empfänger bekanntes Referenzsignal, insbesondere das um 180° phasenverdrehte Signal, übertragen. Die Beeinflussung des Nutzsignals durch Einkopplungen auf dem Übertragungsweg ist auf beiden Leitern nahezu gleichartig, wenn sie die gleiche Quellimpedanz, gleiche Leitungsimpedanz und gleiche Lastimpedanz aufweisen. Bei Differenzbildung der beiden Leiter-Potenziale hebt sich die Störung dann nahezu auf.

Die rechnerseitigen Abschirmelemente weisen Endabschnitte auf, welche ausgelegt und angeordnet sind, um im montierten Zustand jeweils mit zugehörigen und/oder komplementären Endabschnitten der kartenseitigen Abschirmelemente zu überlappen. Mit anderen Worten weisen die rechnerseitigen und kartenseitigen Abschirmelemente zueinander komplementäre Endabschnitte auf. Mit dem Begriff "zueinander komplementär" wird im Sinne dieser Beschreibung insbesondere verstanden, dass die rechnerseitigen und kartenseitigen Abschirmelemente, und damit das rechnerseitige und kartenseitige Gehäuse, derart ausgelegt bzw. geformt und angeordnet sind, dass die Endabschnitte von zugehörigen Abschirmelementen beim Zusammenstecken des rechnerseitigen und kartenseitigen Verbinderelements ineinander eingreifen und/oder sich überlappen können.

Unter einem montierten Zustand wird im Sinne der vorliegenden Beschreibung ein Zustand verstanden, in dem das Verbindersystem bzw. das rechnerseitige und das kartenseitige Verbinderelement bestimmungsgemäß verwendet wird bzw. werden und/oder bestimmungsgemäß montiert, zusammengesetzt oder zusammengesteckt ist bzw. sind. Insbesondere wird unter einem montierten Zustand verstanden, dass das rechnerseitige und kartenseitige Verbinderelement miteinander verbunden sind. Ein montierter Zustand kann daher auch als zusammengebauter Zustand, zusammengesetzter Zustand, zusammengesteckter Zustand und/oder als Betriebszustand bezeichnet werden. Mit anderen Worten bezeichnet der montierte Zustand eines Verbinderelements bzw. Verbindersystems eine bestimmungsgemäße Anordnung oder Einbauposition der einzelnen Elemente des Verbinderelements bzw. Verbindersystems. Unter dem Begriff "Verbinden" wird insbesondere ein mechanisches und/oder elektrisches Verbinden verstanden.

Im Rahmen der vorliegenden Erfindung hat sich gezeigt, dass das erfindungsgemäße kartenseitige und das erfindungsgemäße rechnerseitige Verbinderelement den Anforderungen im Automotive Bereich genügen. Mit Hilfe der in dem rechnerseitigen und dem kartenseitigen Gehäuse ausgebildeten bzw. integrierten rechnerseitigen und kartenseitigen Abschirmelemente, welche sich im montierten Zustand gegenseitig überlappen, kann sowohl die für Automotive Anwendungen notwendige mechanische Stabilität als auch die notwendige Signalgüte gewährleistet werden. Insbesondere wird mittels der in das jeweilige Gehäuse integrierten Abschirmelemente eine durchgehende Abschirmung des Verbinders, insbesondere auch bereits während des Zusammensteckens und/oder Trennens des rechnerseitigen und kartenseitigen Verbinderelements (also beim Öffnen und/oder Schließen der Verbindung), erreicht. Auf diese Weise können die elektromagnetische Verträglichkeit verbessert und eine störungsfreie Signalgewinnung, -übertragung und -verarbeitung gesichert werden. Insbesondere kann auch eine unerwünschte gegenseitige Beeinflussung (Übersprechen) der einzelnen Kontaktelemente, insbesondere der Differential-Pair Kontaktelemente, des Verbinders vermieden oder zumindest vermindert werden. Dadurch dass die Abschirmelemente unmittelbar durch das Gehäuse ausgebildet sind bzw. bereitgestellt werden, sind die Verbinderelemente schnell und kostengünstig herstellbar, so dass sie im Vergleich zu herkömmlichen Verbindern, die den Anforderungen im Automotive Bereich genügen, auch massentauglich sind. Zudem sind die erfindungsgemäßen Verbinderelemente platzsparend.

Durch die Überlappung der jeweiligen Endabschnitte von rechnerseitigen und kartenseitigen Abschirmelementen kann zudem sichergestellt werden, dass kein direkter Luftspalt zwischen benachbarten bzw. übereinanderliegenden Kontaktelementen (Single Pair) entsteht. Im Rahmen der Erfindung hat sich gezeigt, dass beim Zusammenstecken des rechnerseitigen und kartenseitigen Verbinderelements eine gewisse Schwankung in der Stecktiefe, d.h. eine mögliche Schwankung oder Abweichung von einem Sollwert bzw. Idealwert der nach dem Zusammenstecken des rechnerseitigen und kartenseitigen Verbinderelements erreichten Endposition des rechnerseitigen und/oder kartenseitigen Verbinderelements in Steckrichtung bzw. in der ersten Montagerichtung, auftreten kann. Diese Schwankung bzw. Abweichung kann z.B. durch Fertigungstoleranzen der einzelnen Verbinderelemente und/oder durch ein gewisses Spiel im montierten Zustand bedingt sein. Ein typischer Wert einer solchen Schwankung bzw. Abweichung ist z.B. ±1,5 mm. Mit Hilfe des erfindungsgemäßen Überlapps der jeweiligen Endabschnitte von rechnerseitigen und kartenseitigen Abschirmelementen kann eine solche Schwankung bezüglich der Stecktiefe toleriert werden, ohne dass dabei die Qualität (insbesondere die Schirmwirkung) des Verbindersystems beeinträchtigt wird. Mit anderen Worten weist das Stecksystem durch den Überlapp der jeweiligen Endabschnitte eine bestimmte Stecktiefentoleranz auf. Der Überlapp bzw. der Überlappungsgrad ist vorzugsweise derart ausgebildet oder beschaffen, dass die oben beschriebene Stecktiefentoleranz einen für das Stecksystem bestimmbaren oder einen für das Stecksystem bestimmten (d.h. vorgegebenen, vordefinierten oder festgelegten) Wert, z.B. ±1,5 mm, aufweist. Mit anderen Worten ist der Überlapp bzw. der Überlappungsgrad vorzugsweise derart ausgebildet oder beschaffen, dass auch bei einem Ausschöpfen der Stecktiefentoleranz (d.h. beim Erreichen der maximal möglichen Schwankung der Stecktiefe) noch ein (Rest)überlapp vorhanden ist. Auf diese Weise kann z.B. ein Luftspalt zwischen benachbart bzw. übereinander angeordneten Kontaktelementen, insbesondere zwischen benachbart bzw. übereinander angeordneten Differential-Pair Kontaktelementen, selbst dann noch vermieden werden, wenn bei einem Verbindersystem die Stecktiefe (bzw. die Endposition des rechnerseitigen und/oder kartenseitigen Verbinderelements) um den bestimmbaren oder bestimmten Toleranzwert von einer Soll-Stecktiefe (bzw. einer Soll-Endposition) abweicht.

Die rechnerseitigen Abschirmelemente sind integrale Bestandteile des rechnerseitigen Gehäuses, und die kartenseitigen Abschirmelemente sind integrale Bestandteile des kartenseitigen Gehäuses. Der Begriff "integraler Bestandteil" soll nochmals verdeutlichen, dass das rechnerseitige Gehäuse und die rechnerseitigen Abschirmelemente keine separaten Elemente sind, sondern in einem Stück, d.h. einstückig, gefertigt bzw. ausgebildet sind. Entsprechend sind das kartenseitige Gehäuse und die kartenseitigen Abschirmelemente keine separaten Elemente, sondern in einem Stück, d.h. einstückig, gefertigt bzw. ausgebildet. Insbesondere bilden die rechnerseitigen bzw. kartenseitigen Kontakthohlräume jeweils Aussparungen im rechnerseitigen bzw. kartenseitigen Gehäuse.

Die rechnerseitigen Abschirmelemente sind insbesondere als Begrenzungselemente der rechnerseitigen Kontakthohlräume ausgebildet. Alternativ oder zusätzlich sind die kartenseitigen Abschirmelemente als Begrenzungselemente der kartenseitigen Kontakthohlräume ausgebildet. Mit anderen Worten werden die rechnerseitigen bzw. kartenseitigen Kontakthohlräume von den rechnerseitigen bzw. kartenseitigen Abschirmelementen begrenzt. Zudem werden die rechnerseitigen bzw. kartenseitigen Kontakthohlräume durch die rechnerseitigen bzw. kartenseitigen Abschirmelemente voneinander separiert. Die Abschirmelemente stellen somit Boden-, Decken- und/oder Wandelemente bzw. Wandungen der Kontakthohlräume dar.

In einer bevorzugten Ausführungsform sind die Endabschnitte der rechnerseitigen Abschirmelemente und die jeweils zugehörigen komplementären Endabschnitte der kartenseitigen Abschirmelemente derart ausgelegt und angeordnet, dass sie sich im montierten Zustand formschlüssig überlappen. Dabei können sich die jeweiligen Endabschnitte durch den Überlapp kontaktieren, so dass dadurch die rechnerseitigen und kartenseitigen Abschirmelemente und damit auch das rechnerseitige und kartenseitige Gehäuse elektrisch und/oder thermisch miteinander verbunden sind. Es ist jedoch nicht unbedingt erforderlich, dass sich die jeweiligen Endabschnitte kontaktieren, da durch den Überlapp auch eine kapazitive Übertragung gewährleistet werden kann. Auf diese Weise kann im montierten Zustand eine durchgehende Abschirmung und somit eine gute Signalqualität gewährleistet werden. Auch die thermischen Eigenschaften des Verbinders, insbesondere die Wärmeableitung, können dadurch verbessert werden.

In einer weiteren bevorzugten Ausführungsform ist das rechnerseitige Verbinderelement ausgelegt, um entlang einer ersten Montagerichtung mit dem Zentralrechner verbunden, insbesondere zusammengesteckt, zu werden. Das kartenseitige Verbinderelement ist ausgelegt, um entlang einer zweiten Montagerichtung mit der PCB-Karte verbunden, insbesondere zusammengesteckt, zu werden. Ferner sind das rechnerseitige Verbinderelement und das kartenseitige Verbinderelement entlang der ersten Montagerichtung verbindbar bzw. zusammensteckbar. Vorzugsweise unterscheidet sich die erste Montagerichtung von der zweiten Montagerichtung. Insbesondere ist die erste Montagerichtung im Wesentlichen senkrecht zur zweiten Montagerichtung.

In einer weiteren bevorzugten Ausführungsform sind zumindest einige der Endabschnitte der rechnerseitigen Abschirmelemente als Verjüngung der rechnerseitigen Abschirmelemente ausgebildet. Alternativ oder zusätzlich sind zumindest einige der Endabschnitte der kartenseitigen Abschirmelemente jeweils als Verjüngung der kartenseitigen Abschirmelemente ausgebildet. Die verjüngten rechnerseitigen Endabschnitte der rechnerseitigen Abschirmelemente überlappen sich beim Zusammenstecken des rechnerseitigen und kartenseitigen Verbinderelements mit jeweils komplementär verjüngten kartenseitigen Endabschnitten der kartenseitigen Abschirmelemente. Insbesondere weisen diejenigen Abschirmelemente verjüngte Endabschnitte auf, die als Bodenelemente und/oder Deckenelemente fungieren, d.h. die horizontalen bzw. horizontal angeordneten Abschirmelemente. Der Begriff "horizontal" oder "horizontal angeordnet" bedeutet im Sinne dieser Beschreibung eine Anordnung entlang der ersten Montagerichtung. Entsprechend bedeutet der Begriff "vertikal" oder "vertikal angeordnet" eine Anordnung entlang der zweiten Montagerichtung.

In einer weiteren bevorzugten Ausführungsform weisen zumindest einige der rechnerseitigen Abschirmelemente rechnerseitige Anschlagabschnitte auf, welche ein Eindringen der kartenseitigen Endabschnitte von jeweils zugehörigen kartenseitigen Abschirmelementen in das rechnerseitige Verbinderelement, insbesondere entgegen der ersten Montagerichtung, begrenzen. Alternativ oder zusätzlich weisen zumindest einige der kartenseitigen Abschirmelemente kartenseitige Anschlagabschnitte auf, welche ein Eindringen der rechnerseitigen Endabschnitte von jeweils zugehörigen rechnerseitigen Abschirmelementen in das kartenseitige Verbinderelement, insbesondere entlang der ersten Montagerichtung, begrenzen.

Vorzugsweise sind die rechnerseitigen bzw. kartenseitigen Anschlagabschnitte jeweils als Kante, welche durch eine Verjüngung der Endabschnitte jeweiliger rechnerseitiger bzw. kartenseitiger Abschirmelemente entsteht, ausgebildet. Mittels der Anschlagabschnitte können vorteilhafterweise andere Verbinderteile vor übermäßigen Kräften beim Zusammenstecken der Verbinderelemente geschützt werden. Zudem kann eine optimale Anordnung und damit Kontaktierung der rechnerseitigen Kontaktelemente mit den kartenseitigen Kontaktelementen im montierten Zustand erreicht werden.

In einer weiteren bevorzugten Ausführungsform weist das rechnerseitige Verbinderelement eine Vielzahl von rechnerseitigen Differential-Pair Kontaktelementpaaren auf, wobei jedes rechnerseitige Differential-Pair Kontaktelementpaar in einem der von den rechnerseitigen Abschirmelementen ausgebildeten rechnerseitigen Kontakthohlräumen zumindest bereichsweise angeordnet ist. Zusätzlich weist das kartenseitige Verbinderelement eine Vielzahl von kartenseitigen Differential-Pair Kontaktelementpaaren auf, wobei jedes kartenseitige Differential-Pair Kontaktelementpaar in einem der von den kartenseitigen Abschirmelementen ausgebildeten kartenseitigen Kontakthohlräumen zumindest bereichsweise angeordnet ist. Im Rahmen der vorliegenden Erfindung hat sich herausgestellt, dass es für Automotive Anwendungen hinsichtlich der erforderlichen Übertragungsqualität und der Frequenzbereiche vorteilhaft ist, eine symmetrische Signalübertragung mit Hilfe von Differential-Pair Kontaktelementen bereitzustellen. Ferner hat sich im Rahmen der vorliegenden Erfindung herausgestellt, dass gerade für solche Differential-Pair Kontaktelemente hinsichtlich der für den Automotive Bereich notwendigen Signalqualität eine gute Schirmung entscheidend bzw. erforderlich ist.

In einer weiteren bevorzugten Ausführungsform weisen die rechnerseitigen Endabschnitte der rechnerseitigen Abschirmelemente und die kartenseitigen Endabschnitte der kartenseitigen Abschirmelemente eine im Wesentlichen gleiche Länge L auf.

In einer weiteren bevorzugten Ausführungsform ist die Länge L derart gewählt, dass sich bei einem Zusammenstecken des rechnerseitigen Verbinderelements und des kartenseitigen Verbinderelements die rechnerseitigen Endabschnitte und die kartenseitigen Endabschnitte bereits überlappen noch bevor sich die rechnerseitigen Differential-Pair Kontaktelementpaare und die kartenseitigen Differential-Pair Kontaktelementpaare vollständig kontaktieren. Unter "vollständig kontaktieren" wird im Sinne dieser Beschreibung verstanden, dass die rechnerseitigen Differential-Pair Kontaktelementpaare die kartenseitigen Differential-Pair Kontaktelementpaare an zumindest zwei vorgesehenen, unterschiedlichen Kontaktstellen der kartenseitigen Kontaktelemente kontaktieren. Die Länge L kann z.B. 3 mm betragen. Im Rahmen der Erfindung hat sich gezeigt, dass bei einer Länge von L ≈ 3 mm im montierten bzw. zusammengesteckten Zustand ein ausreichend großer Überlapp der Endabschnitte von rechnerseitigen und kartenseitigen Abschirmelementen vorliegt, so dass eine oben beschriebene Stecktiefentoleranz von etwa ±1,5 mm erreicht wird.

In einer weiteren bevorzugten Ausführungsform weisen die kartenseitigen Differential-Pair Kontaktelemente wellenförmige Endabschnitte auf, um bei einem Überlapp mit einem rechnerseitigen Differential-Pair Kontaktelement das zugehörige rechnerseitige Differential-Pair Kontaktelement an zumindest zwei unterschiedlichen Kontaktstellen elektrisch zu kontaktieren. Die Länge L der rechnerseitigen und/oder kartenseitigen Endabschnitte ist zudem derart gewählt, dass im montierten bzw. vollständig zusammengesteckten Zustand die kartenseitigen und rechnerseitigen Differential-Pair Kontaktelemente derart überlappen, dass sie sich an den zumindest zwei vorgesehenen Kontaktstellen berühren bzw. kontaktieren.

Auch wenn in Folge der wellenartigen Abschnitte eine antennenartige Wirkung und somit Störsignale erwartet werden könnten, so hat sich im Rahmen der vorliegenden Erfindung überraschenderweise herausgestellt, dass dadurch die Qualität für die im Automotive Bereich übertragenen Signale bzw. Frequenzen nicht nennenswert beeinträchtigt werden. Vielmehr kann die Signalübertragung durch die wellenartige Form der kartenseitigen Kontaktelemente, insbesondere hinsichtlich Zuverlässigkeit, gesteigert werden, ohne dass die Kontaktstelle z.B. aufwendig verlötet werden muss.

In einer weiteren bevorzugten Ausführungsform ragen die rechnerseitigen Differential-Pair Kontaktelemente, insbesondere in Richtung der ersten Montagerichtung, über die rechnerseitigen Abschirmelemente hinaus. Alternativ oder zusätzlich ragen die kartenseitigen Abschirmelemente, insbesondere entgegen der ersten Montagerichtung, über die kartenseitigen Differential-Pair Kontaktelemente hinaus.

In einer weiteren bevorzugten Ausführungsform sind das rechnerseitige Gehäuse und das kartenseitige Gehäuse jeweils aus Zinkdruckguss gefertigt. Mit dem rechnerseitigen und kartenseitige Gehäuse sind somit auch die rechnerseitigen und kartenseitigen Abschirmelemente aus Zinkdruckguss ausgebildet bzw. gefertigt. Vorzugsweise ist das Zinkdruckguss-Material ein EZDA3 (Zinc Die Casting Alloy) und insbesondere eine in der Norm EN 12844 beschriebene ZP0410-, ZP0400- und/oder ZPO430-Legierung. Es versteht sich, dass aber auch alternative Zinkdruckguss-Materialien verwendet werden können. Insbesondere ist das rechnerseitige Zinkdruckguss-Gehäuse einstückig ausgebildet, d.h. es ist nicht aus mehreren Teilen zusammengesetzt, sondern umfasst lediglich ein einziges Teil aus einem Zinndruckguss-Material. Das rechnerseitige und kartenseitige Zinkdruckguss-Gehäuse sorgen vorteilhafterweise für die erforderliche Schirmwirkung der Abschirmelemente und somit für eine hohe Signalqualität.

Das rechnerseitige Verbinderelement kann ferner eine Vielzahl von rechnerseitigen hohlförmigen Isolierkörpern aufweisen, welche im montierten Zustand innerhalb der rechnerseitigen Kontakthohlräume angeordnet und zur Aufnahme entsprechender Kontaktelemente vorgesehen und ausgelegt sind. Vorzugsweise sind die rechnerseitigen Isolierkörper aus den Materialien PA9T, PA10T oder LCP ausgebildet bzw. gefertigt. Die Anzahl der rechnerseitigen Isolierkörper entspricht vorzugsweise der Anzahl an rechnerseitigen Kontakthohlräumen. Die rechnerseitigen Isolierkörper sind vorzugsweise rechteckförmig ausgebildet.

Das rechnerseitige Verbinderelement kann eine Vielzahl von rechnerseitigen Kontaktelementen, insbesondere Kontaktstifte, aufweisen. Vorzugsweise sind die rechnerseitigen Kontaktelemente aus CuSn6 oder alternativen Kupferlegierungen ausgebildet bzw. gefertigt. Als Kontaktelement werden allgemein elektrische Leiter verstanden, mit denen elektrische Signale übertragen werden können. Die rechnerseitigen Kontaktelemente können im montierten Zustand zumindest bereichsweise innerhalb von rechnerseitigen Isolierhohlräumen der rechnerseitigen Isolierkörper, und damit auch innerhalb der rechnerseitigen Kontakthohlräume, angeordnet sein. Mit anderen Worten können die rechnerseitigen Isolierkörper die rechnerseitigen Kontaktelemente zumindest bereichsweise umgeben. "Zumindest bereichsweise" bedeutet in diesem Zusammenhang, dass jeweils zumindest ein Abschnitt eines rechnerseitigen Kontaktelements innerhalb eines rechnerseitigen Isolierhohlraums eines rechnerseitigen Isolierkörpers angeordnet ist bzw. dass ein rechnerseitiger Isolierkörper zumindest einen Abschnitt eines rechnerseitigen Kontaktelements umgibt. Insbesondere sind die rechnerseitigen Kontaktelemente im montierten Zustand zumindest bereichsweise innerhalb von rechnerseitigen Isolierhohlräumen der rechnerseitigen Isolierkörper angeordnet, so dass sie gegenüber dem rechnerseitigen Gehäuse elektrisch isoliert sind. Die rechnerseitigen Kontaktelemente können das rechnerseitige Gehäuse im Wesentlichen vollständig durchdringen.

Abgesehen von der isolierenden Wirkung dienen die rechnerseitigen Isolierkörper auch dazu, die rechnerseitigen Kontaktelemente in den rechnerseitigen Kontakthohlräumen zu halten bzw. zu befestigen. Die Isolierkörper haben somit neben ihrer Isolierfunktion auch eine Stabilitätsfunktion, d.h. eine Halte- bzw. Befestigungsfunktion. An den Stellen bzw. Abschnitten der Kontaktelemente, die nicht von einem Isolierkörper umgeben sind, kann Luft als Isolator dienen.

Ein Steckende der rechnerseitigen Kontaktelemente kann aus dem rechnerseitigen Gehäuse herausragen und zum Kontaktieren des Zentralrechners ausgebildet sein.

Das kartenseitige Gehäuse kann zweistückig ausgebildet sein, d.h. es kann aus genau zwei Teilen, nämlich einem ersten kartenseitigen Gehäuseelement und einem zweiten kartenseitigen Gehäuseelement, vorzugsweise jeweils aus Zinkdruckguss, zusammengesetzt sein. Dabei weist insbesondere das erste kartenseitige Gehäuseelement die kartenseitigen Abschirmelemente auf. Die kartenseitigen Kontakthohlräume sind insbesondere komplementär zu den rechnerseitigen Kontakthohlräumen angeordnet. Mit anderen Worten gibt es zu jedem rechnerseitigen Kontakthohlraum einen zugehörigen bzw. komplementären kartenseitigen Kontakthohlraum.

Das kartenseitige Verbinderelement kann ferner eine Vielzahl von hohlförmigen kartenseitigen Isolierkörpern aufweisen, welche im montierten Zustand innerhalb der kartenseitigen Kontakthohlräume angeordnet und zur Aufnahme entsprechender Kontaktelemente vorgesehen und ausgelegt sind. Vorzugsweise sind die kartenseitigen Isolierkörper aus den Materialien PA9T, PA10T oder LCP ausgebildet bzw. gefertigt. Die kartenseitigen Isolierkörper können kartenseitige Isolierhohlräume aufweisen, die ausgelegt sind, um im montierten Zustand die rechnerseitigen Kontaktelemente zumindest bereichsweise aufzunehmen. Mit anderen Worten können im montierten Zustand die rechnerseitigen Kontaktelemente in den kartenseitigen Isolierkörper eindringen, um die kartenseitigen Kontaktelemente zu kontaktieren. Die Anzahl der kartenseitigen Isolierkörper entspricht vorzugsweise der Anzahl von kartenseitigen Kontakthohlräumen. Die Anzahl der rechnerseitigen Isolierkörper entspricht vorzugsweise der Anzahl von rechnerseitigen Kontakthohlräumen. Weiter vorzugsweise entspricht die Anzahl von rechnerseitigen Kontakthohlräumen der Anzahl von kartenseitigen Kontakthohlräumen. Die kartenseitigen Isolierkörper sind vorzugsweise rechteckförmig ausgebildet.

Insbesondere weist das kartenseitige Verbinderelement eine Vielzahl von kartenseitigen Kontaktelementen auf. Vorzugsweise sind die kartenseitigen Kontaktelemente aus CuSn6 oder alternativen Kupferlegierungen ausgebildet bzw. gefertigt. Die kartenseitigen Kontaktelemente können im montierten Zustand zumindest bereichsweise innerhalb von kartenseitigen Isolierhohlräumen der kartenseitigen Isolierkörper, und damit auch innerhalb der kartenseitigen Kontakthohlräume, angeordnet sein. Mit anderen Worten können die kartenseitigen Isolierkörper die kartenseitigen Kontaktelemente zumindest bereichsweise umgeben. Der Begriff "zumindest bereichsweise" bedeutet in diesem Zusammenhang, dass jeweils zumindest ein Abschnitt eines kartenseitigen Kontaktelements innerhalb eines kartenseitigen Isolierhohlraums eines kartenseitigen Isolierkörpers angeordnet ist bzw. dass ein kartenseitiger Isolierkörper zumindest einen Abschnitt eines kartenseitigen Kontaktelements umgibt. Insbesondere sind die kartenseitigen Kontaktelemente im montierten Zustand zumindest bereichsweise innerhalb von kartenseitigen Isolierhohlräumen der kartenseitigen Isolierkörper angeordnet, so dass sie gegenüber dem kartenseitigen Gehäuse elektrisch isoliert sind. Die kartenseitigen Kontaktelemente sind vorzugsweise derart ausgelegt und angeordnet, dass sie im montierten Zustand jeweils zugehörige rechnerseitige Kontaktelemente kontaktieren. Die Kontaktierung der rechnerseitigen und kartenseitigen Kontaktelemente erfolgt insbesondere innerhalb der kartenseitigen Kontakthohlräume bzw. innerhalb der kartenseitigen Isolierkörper.

Ein Steckende der kartenseitigen Kontaktelemente kann aus dem kartenseitigen Gehäuse herausragen und zum Kontaktieren der PCB-Karte ausgebildet sein.

Abgesehen von der isolierenden Wirkung dienen die kartenseitigen Isolierkörper auch dazu, die kartenseitigen Kontaktelemente in den kartenseitigen Kontakthohlräumen zu halten bzw. zu befestigen. Die kartenseitigen Isolierkörper haben also sowohl eine Isolierfunktion als auch eine Stabilitätsfunktion. An den Stellen bzw. Abschnitten der kartenseitigen Kontaktelemente, die nicht von einem kartenseitigen Isolierkörper umgeben sind, kann Luft als Isolator dienen.

Vorzugsweise weist das rechnerseitige Gehäuse zumindest ein Eingriffelement auf, welches im montierten Zustand in zumindest ein komplementäres Eingriffelement des kartenseitigen Gehäuses eingreift. Das Eingriffelement kann z.B. ein Vorsprung sein und das komplementäre Eingriffelement eine zugehörige Öffnung. Auf diese Weise wird eine stabile und zugleich kontinuierliche bzw. durchgehende Verbindung der rechnerseitigen und kartenseitigen Kontakthohlräume geschaffen bzw. unterstützt. Dies bewirkt vorteilhafterweise eine hohe Stabilität sowie gleichzeitig eine durchgehende Schirmwirkung. Die Qualität der Signalübertragung zwischen der PCB-Karte und dem Zentralrechner kann dadurch erhöht werden und genügt insbesondere den Anforderungen im Automotive Bereich.

Weiter vorzugsweise sind die kartenseitigen Kontakthohlräume und die kartenseitigen Kontaktelemente jeweils gebogen ausgebildet, so dass sie eine im Wesentlichen rechtwinklige Kante aufweisen. Mit anderen Worten sind die kartenseitigen Kontakthohlräume und die kartenseitigen Kontaktelemente im Wesentlichen rechtwinklig ausgebildet. Eine im Wesentlichen rechtwinklige Kante bedeutet im Rahmen dieser Erfindung, dass Abschnitte der kartenseitigen Kontakthohlräume bzw. der kartenseitigen Kontaktelemente vor und nach der "Kante" im rechten Winkel zueinander stehen. Dabei ist die "Kante" selbst bzw. der Bereich, in dem sich die Richtung ändert, in der Regel nicht ideal rechtwinklig ausgebildet, sondern kann vielmehr eine Rundung aufweisen.

Im Rahmen der Erfindung soll insbesondere bedeuten, dass "im Wesentlichen" eine Eigenschaft erfüllt wird, wenn diese Eigenschaft zu zumindest 90% erfüllt wird, bevorzugt zu zumindest 95%, besonders bevorzugt zu zumindest 99%. Insbesondere kann diese Eigenschaft zu 100% erfüllt sein.

Weiter bevorzugt weisen die kartenseitigen Kontakthohlräume und die kartenseitigen Kontaktelemente eine im Wesentlichen rechtwinklige Kante auf und sind im montierten Zustand derart angeordnet, dass die im Wesentlichen rechtwinkligen Kanten zumindest eines Teils der kartenseitigen Kontakthohlräume und die im Wesentlichen rechtwinkligen Kanten zumindest eines Teils der kartenseitigen Kontaktelemente auf einer Geraden in einer von der ersten und zweiten Montagerichtung (bzw. von entsprechenden Richtungsvektoren) aufgespannten Ebene liegen, wobei die erste Montagerichtung im Wesentlichen senkrecht zur zweiten Montagerichtung ist und die Gerade sowohl zur ersten Montagerichtung als auch zur zweiten Montagerichtung, d.h. zu den entsprechenden Richtungsvektoren, einen Winkel von etwa 45° aufweist. Im Rahmen der vorliegenden Erfindung hat sich gezeigt, dass mit einer derartigen Ausführungsform den Anforderungen im Automotive Bereich, insbesondere hinsichtlich der notwendigen Signalqualität einerseits und einer möglichst hohen Platzeinsparung andererseits, besonders gut gerecht werden kann.

Weiter bevorzugt weist das kartenseitige Gehäuse ein erstes kartenseitiges Gehäuseelement mit einem ersten Endabschnitt und ein zweites kartenseitiges Gehäuseelement mit einem zu dem ersten kartenseitigen Gehäuseelement komplementären zweiten Endabschnitt auf. Der erste Endabschnitt weist insbesondere eine erste Öffnung auf, während der zweite Endabschnitt insbesondere eine zweite Öffnung aufweist. Der erste Endabschnitt bzw. die erste Öffnung und der zweite Endabschnitt bzw. die zweite Öffnung sind miteinander verbindbar. Im verbundenen Zustand bilden sie eine Verbindungsebene aus, welche sowohl zur ersten als auch zur zweiten Montagerichtung einen Winkel von etwa 45° aufweist. Dabei ist die erste Montagerichtung senkrecht zur zweiten Montagerichtung. Insbesondere ist das erste kartenseitige Gehäuseelement ausgelegt, um mit dem rechnerseitigen Gehäuseelement verbunden zu werden, während das zweite kartenseitige Gehäuseelement ausgelegt ist, um an die PCB-Karte angeschlossen zu werden. Dadurch dass das kartenseitige Gehäuse ein erstes und zweites kartenseitiges Gehäuseelement aufweist, wird vorteilhafterweise die Herstellung und die Montage des Verbindersystems vereinfacht.

Weiter bevorzugt weist das kartenseitige Gehäuse ein erstes kartenseitiges Gehäuseelement mit den oben beschriebenen (ersten) kartenseitigen Kontakthohlräumen, die sich entlang der ersten Montagerichtung erstrecken, auf. Zusätzlich kann das kartenseitige Gehäuse ein zweites kartenseitiges Gehäuseelement mit zu den ersten kartenseitigen Kontakthohlräumen zugehörigen zweiten kartenseitigen Kontakthohlräumen, die sich entlang der zweiten Montagerichtung erstrecken, aufweisen. Das erste und zweite kartenseitige Gehäuseelement sind im montierten Zustand derart miteinander verbunden, dass jeweils die ersten und die zugehörigen zweiten kartenseitigen Kontakthohlräume durch das kartenseitige Gehäuse durchgängige Kanäle ausbilden. Unter einem durchgängigen oder zusammenhängenden Kanal wird ein zusammenhängender oder durchgehender kartenseitiger Hohlraum verstanden. Insbesondere entsprechen die durch die ersten und/oder zugehörigen zweiten kartenseitigen Kontakthohlräume ausgebildeten Kanäle den oben beschriebenen kartenseitigen Kontakthohlräumen. Auf diese Weise kann eine für den Automotive Bereich notwendige hohe Signalqualität durch eine optimale und durchgehende Schirmung der Kontaktelemente, d.h. der signalübertragenden Leiter, erreicht werden.

Weiter vorzugsweise weisen sämtliche erste kartenseitigen Kontakthohlräume, welche in ein und derselben, von der ersten und zweiten Montagerichtung aufgespannten, Ebene angeordnet sind, relativ zueinander eine unterschiedliche Länge auf. Ferner sind diese ersten kartenseitigen Kontakthohlräume stufenförmig angeordnet. Insbesondere sind Endabschnitte sämtlicher erster kartenseitiger Kontakthohlräume, welche in ein und derselben von der ersten und zweiten Montagerichtung aufgespannten Ebene angeordnet sind, entlang der ersten Montagerichtung relativ zueinander versetzt (d.h. stufenförmig) angeordnet. Entsprechend weisen sämtliche zweite kartenseitigen Kontakthohlräume, welche in ein und derselben, von der ersten und zweiten Montagerichtung aufgespannten, Ebene angeordnet sind, relativ zueinander eine unterschiedliche Länge auf und sind stufenförmig angeordnet. Insbesondere sind Endabschnitte sämtlicher zweiter kartenseitiger Kontakthohlräume, welche in ein und derselben, von der ersten und zweiten Montagerichtung aufgespannten, Ebene angeordnet sind, entlang der zweiten Montagerichtung relativ zueinander versetzt (d.h. stufenförmig) angeordnet. Im Rahmen der vorliegenden Erfindung hat sich gezeigt, dass mit einer derartigen Ausführungsform den Anforderungen im Automotive Bereich, insbesondere hinsichtlich der notwendigen Signalqualität einerseits und einer möglichst hohen Platzeinsparung andererseits besonders gut gerecht werden kann.

Weiter bevorzugt weist das rechnerseitige Gehäuse zumindest ein Stabilisierungselement und das kartenseitige Gehäuse zumindest ein komplementäres Stabilisierungselement auf. Das zumindest eine Stabilisierungselement kann z.B. eine Aussparung oder eine Nut umfassen, während das komplementäre Stabilisierungselement einen Vorsprung, insbesondere einen Stabilisierungsstift bzw. einen Steckstift, welcher mit der Aussparung oder der Nut in Eingriff bringbar ist, umfassen kann. Auf diese Weise kann eine erhöhte Stabilität des Verbindersystems erreicht werden, was vor allem im Automotive Bereich wichtig ist, um einen Signalausfall zu vermeiden. Ferner dienen die Stabilisatoren zusätzlich als Steckhilfe.

Weiter bevorzugt weist das kartenseitige Gehäuse zumindest ein Federelement auf, welches das kartenseitige Gehäuse elektrisch kontaktiert und welches ausgelegt ist, um im montierten Zustand auch das rechnerseitige Gehäuse elektrisch zu kontaktieren. Mit Hilfe des Federelements wird das kartenseitige Gehäuse mit dem rechnerseitigen Gehäuse elektrisch verbunden, was die Schirmwirkung und damit die Signalqualität des Verbindersystems weiter erhöht.

Weiter bevorzugt weist das kartenseitige Gehäuse, und insbesondere das zweite kartenseitige Gehäuseelement, Lötstellen auf, um auf die PCB-Karte gelötet zu werden. Auch dies bewirkt eine verbesserte Schirmung und damit eine verbesserte Signalqualität des Verbindersystems.

Vorzugsweise weist das rechnerseitige Gehäuse neben den oben beschriebenen rechnerseitigen Differential-Pair-Kontakthohlräumen auch noch einen rechnerseitigen Power-Kontakthohlraum und einen rechnerseitigen Single-End-Kontakthohlraum auf. Ferner umfasst die Vielzahl von rechnerseitigen Isolierkörpern vorzugsweise einen rechnerseitigen Power-Isolierkörper, welcher im montierten Zustand in dem rechnerseitigen Power-Kontakthohlraum angeordnet ist, einen rechnerseitigen Single-End-Isolierkörper, welcher im montierten Zustand in dem rechnerseitigen Single-End-Kontakthohlraum angeordnet ist, und eine Vielzahl von rechnerseitigen Differential-Pair-Isolierkörpern, welche im montierten Zustand jeweils in einem zugehörigen rechnerseitigen Differential-Pair-Kontakthohlraum der Vielzahl von rechnerseitigen Differential-Pair-Kontakthohlräumen angeordnet ist. Ferner umfasst die Vielzahl von rechnerseitigen Kontaktelementen vorzugsweise eine Vielzahl von rechnerseitigen Power-Kontaktelementen, welche im montierten Zustand zumindest bereichsweise in Hohlräumen des rechnerseitigen Power-Isolierkörpers angeordnet sind, eine Vielzahl von rechnerseitigen Single-End-Kontaktelementen, welche im montierten Zustand zumindest bereichsweise in Hohlräumen des rechnerseitigen Single-End-Isolierkörpers angeordnet sind, und eine Vielzahl von rechnerseitigen Differential-Pair-Kontaktelementen, welche im montierten Zustand jeweils zumindest bereichsweise in einem Hohlraum eines zugehörigen rechnerseitigen Differential-Pair-Isolierkörpers der Vielzahl von rechnerseitigen Differential-Pair-Isolierkörpern angeordnet sind.

Entsprechend weist das kartenseitige Gehäuse vorzugsweise neben den oben beschriebenen kartenseitigen Differential-Pair-Kontakthohlräumen auch noch einen kartenseitigen Power-Kontakthohlraum und einen kartenseitigen Single-End-Kontakthohlraum auf. Ferner umfasst die Vielzahl von kartenseitigen Isolierkörpern vorzugsweise einen kartenseitigen Power-Isolierkörper, welcher im montierten Zustand in dem kartenseitigen Power-Kontakthohlraum angeordnet ist, einen kartenseitigen Single-End-Isolierkörper, welcher im montierten Zustand in dem kartenseitigen Single-End-Kontakthohlraum angeordnet ist, und eine Vielzahl von kartenseitigen Differential-Pair-Isolierkörpern, welche im montierten Zustand jeweils in einem zugehörigen kartenseitigen Differential-Pair-Kontakthohlraum der Vielzahl von kartenseitigen Differential-Pair-Kontakthohlräumen angeordnet ist. Ferner umfasst die Vielzahl von kartenseitigen Kontaktelementen vorzugsweise eine Vielzahl von kartenseitigen Power-Kontaktelementen, welche im montierten Zustand zumindest bereichsweise in Hohlräumen des kartenseitigen Power-Isolierkörpers angeordnet sind, eine Vielzahl von kartenseitigen Single-End-Kontaktelementen, welche im montierten Zustand zumindest bereichsweise in Hohlräumen des kartenseitigen Single-End-Isolierkörpers angeordnet sind, und eine Vielzahl von kartenseitigen Differential-Pair-Kontaktelementen, welche im montierten Zustand jeweils zumindest bereichsweise in einem Hohlraum eines zugehörigen kartenseitigen Differential-Pair-Isolierkörpers der Vielzahl von kartenseitigen Differential-Pair-Isolierkörpern angeordnet sind.

Beispielsweise können 48 rechnerseitige und 48 kartenseitige Differential-Pair-Kontakthohlräume vorgesehen sein. Entsprechend können 48 rechnerseitige und 48 kartenseitige Differential-Pair-Isolierkörper sowie 48 rechnerseitige und 48 kartenseitige Differential-Pair-Kontaktelementpaare vorgesehen sein, wobei jedes Differential-Pair-Kontaktelementpaar zwei Kontaktelemente umfasst. Beispielsweise können 8 rechnerseitige und 8 kartenseitige Powerkontakte vorgesehen sein, wobei jeweils vier der kartenseitigen und rechnerseitigen Powerkontakte zwei Powerkontaktpins umfassen und wobei jeweils die restlichen vier kartenseitigen und rechnerseitigen Powerkontakte drei Powerkontaktpins umfassen. Beispielsweise können 56 rechnerseitige und 56 kartenseitige Single-End-Kontaktelemente vorgesehen sein.

Vorteilhafterweise sind sämtliche Power-Kontakthohlräume bzw. Power-Isolierkörper bzw. Power-Kontaktelemente auf einer Seite, d.h. einem Endabschnitt des rechnerseitigen bzw. kartenseitigen Verbinderelements bzw. Gehäuses angeordnet. Somit können Störeinflüsse bei der Signalübertragung reduziert oder vermieden werden. Weiterhin entsteht dadurch der Vorteil, dass bei dem mit dem Verbindersystem zu verbindenden Zentralrechner und bei der mit dem Verbindersystem zu verbindenden PCB-Karte die dort verlaufenden breiten Powerleitungen und somit auch sämtliche Verbraucher auf einer Seite des Zentralrechners bzw. der PCB-Karte angeordnet werden können. Würden hingegen die Powerleitungen an verschiedenen Stellen, d.h. nicht nur auf einer Seite, des Verbindersystems angeordnet sein, so müßten die Powerleitungen im Zentralrechner und/oder auf der PCB-Karte gekreuzt verlaufen, was insgesamt zu einem höheren Platzbedarf führen würde.

Ein erster unabhängiger Aspekt zur Lösung der Aufgabe betrifft ein rechnerseitiges Verbinderelement nach Anspruch 1.

Ein zweiter unabhängiger Aspekt zur Lösung der Aufgabe betrifft ein kartenseitiges Verbinderelement nach Anspruch 2.

Für die oben genannten weiteren unabhängigen Aspekte und insbesondere für diesbezügliche bevorzugte Ausführungsformen gelten auch die vor- oder nachstehend gemachten Ausführungen zu den Ausführungsformen des ersten Aspekts. Insbesondere gelten für einen unabhängigen Aspekt der vorliegenden Erfindung und für diesbezügliche bevorzugte Ausführungsformen auch die vor- und nachstehend gemachten Ausführungen zu den Ausführungsformen der jeweils anderen unabhängigen Aspekte.

Im Folgenden werden einzelne Ausführungsformen zur Lösung der Aufgabe anhand der Figuren beispielhaft beschrieben. Dabei weisen die einzelnen beschriebenen Ausführungsformen zum Teil Merkmale auf, die nicht zwingend erforderlich sind, um den beanspruchten Gegenstand auszuführen, die aber in bestimmten Anwendungsfällen gewünschte Eigenschaften bereitstellen. So sollen auch Ausführungsformen als unter die beschriebene technische Lehre fallend offenbart angesehen werden, die nicht alle Merkmale der im Folgenden beschriebenen Ausführungsformen aufweisen. Ferner werden, um unnötige Wiederholungen zu vermeiden, bestimmte Merkmale nur in Bezug auf einzelne der im Folgenden beschriebenen Ausführungsformen erwähnt. Es wird darauf hingewiesen, dass die einzelnen Ausführungsformen daher nicht nur für sich genommen, sondern auch in einer Zusammenschau betrachtet werden sollen. Anhand dieser Zusammenschau wird der Fachmann erkennen, dass einzelne Ausführungsformen auch durch Einbeziehung von einzelnen oder mehreren Merkmalen anderer Ausführungsformen modifiziert werden können. Es wird darauf hingewiesen, dass eine systematische Kombination der einzelnen Ausführungsformen mit einzelnen oder mehreren Merkmalen, die in Bezug auf andere Ausführungsformen beschrieben werden, wünschenswert und sinnvoll sein kann und daher in Erwägung gezogen und auch als von der Beschreibung umfasst angesehen werden soll.

### Kurze Beschreibung der Zeichnungen

- Figur 1: zeigt in einer perspektivischen Explosionsansicht eine schematische Skizze eines Verbindersystems gemäß einer bevorzugten Ausführungsform der vorliegenden Erfindung;
- Figur 2A: zeigt in einer ersten perspektivischen Ansicht (Vorderansicht) eine schematische Skizze des rechnerseitigen Gehäuses des Verbindersystems aus Figur 1;
- Figur 2B: zeigt in einer zweiten perspektivischen Ansicht (Rückansicht) eine schematische Skizze des rechnerseitigen Gehäuses des Verbindersystems aus Figur 1;
- Figur 3: zeigt in einer perspektivischen Ansicht (Rückansicht) einen Schnitt durch das rechnerseitige Verbinderelement des Verbindersystems von Figur 1;
- Figur 4: zeigt in der perspektivischen Ansicht aus Figur 2A (Vorderansicht) eine schematische Skizze des rechnerseitigen Verbinderelements des Verbindersystems aus Figur 1 ohne das rechnerseitige Gehäuse.
- Figur 5: zeigt in einer perspektivischen Ansicht (Vorderansicht) einen Schnitt durch das rechnerseitige Verbinderelement des Verbindersystems von Figur 1;
- Figur 6a: zeigt in einer Seitenansicht einen Schnitt durch das Verbindersystem von Figur 1 im demontierten Zustand; und
- Figur 6b: zeigt in einer Seitenansicht einen Schnitt durch das Verbindersystem von Figur 1 im montierten bzw. zusammengesteckten Zustand.

### Detaillierte Beschreibung der Zeichnungen

Die in der vorliegenden Beschreibung gewählten Lageangaben, wie z. B. oben, unten, seitlich usw. sind jeweils auf die unmittelbar beschriebene sowie dargestellte Figur bezogen und sind bei einer Lageänderung sinngemäß auf die neue Lage zu übertragen. Die Zusatzbezeichnung "rechnerseitig", wie sie in der vorliegenden Beschreibung für verschiedene Elemente verwendet wird, soll andeuten, dass diese Elemente zu dem rechnerseitigen Verbinderelement, d.h. einem Verbinderelement, welches unmittelbar mit dem Zentralrechner verbunden werden kann, gehören. Entsprechend deutet die Zusatzbezeichnung "kartenseitig" bei verschiedenen Elementen an, dass diese Elemente zu dem kartenseitigen Verbinderelement, d.h. einem Verbinderelement, welches unmittelbar mit einer PCB-Karte verbunden werden kann, gehören.

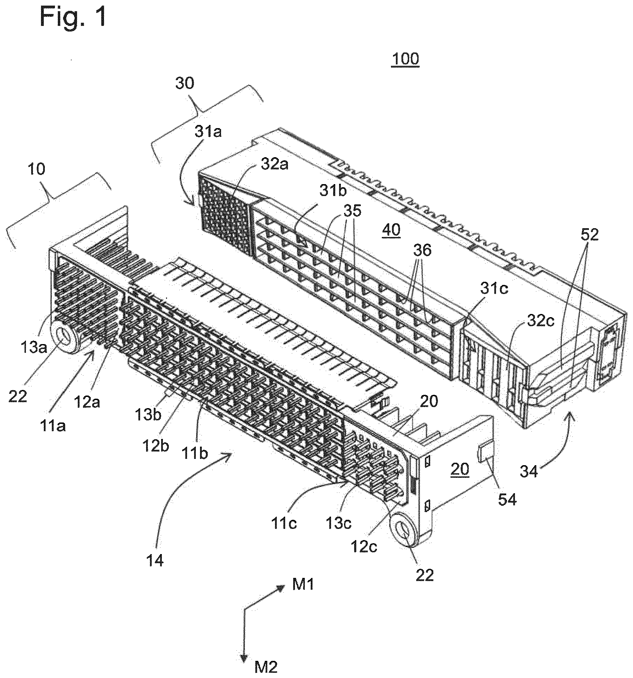

Die **Figur 1** zeigt in einer perspektivischen Explosionsansicht eine schematische Skizze eines erfindungsgemäßen Verbindersystems 100. In dieser Explosionsansicht ist ein rechnerseitiges Verbinderelement 10 und ein kartenseitiges Verbinderelement 30 des Verbindersystems 100 separat, d.h. in einem nicht zusammengesteckten bzw. montierten Zustand gezeigt. Im vollständig montierten Zustand sind das rechnerseitige Verbinderelement 10 und das kartenseitige Verbinderelement 30 miteinander verbunden, d.h. entlang einer mit einem Pfeil gekennzeichneten ersten Montagerichtung M1 zusammengesteckt.

Das rechnerseitige Verbinderelement 10 ist ausgelegt, um mit einer rechnerseitigen Steckseite 14 voran an einen Zentralrechner eines Kraftfahrzeugs (nicht gezeigt) angeschlossen bzw. angesteckt zu werden. Im gezeigten Ausführungsbeispiel ist die Steckseite 14 im montierten Zustand diejenige Seite des rechnerseitigen Verbinderelements 10, welche dem kartenseitigen Verbinderelement 30 abgewandt ist. Eine Normale auf die rechnerseitige Steckseite 14 ist etwa entgegengesetzt parallel zur ersten Montagerichtung M1 angeordnet.

Das rechnerseitige Verbinderelement 10 weist eine Mehrzahl von Kontaktelementen 13a, 13b und 13c auf, die mit komplementären Kontaktelementen des Zentralrechners verbunden werden können. Im Ausführungsbeispiel der Figur 1 weist das Verbindersystem 100 bzw. das rechnerseitige Verbinderelement 10 (und analog dazu das kartenseitige Verbinderelement 30) drei unterschiedliche Kontaktbereiche auf, nämlich einen Single-End-Kontaktbereich mit einer Mehrzahl von Single-End-Kontaktelementen 13a, einen Differential-Pair-Kontaktbereich mit einer Mehrzahl von Differential-Pair-Kontaktelementen 13b und einen Power-Kontaktbereich mit einer Mehrzahl von Power-Kontaktelementen 13c. Während die Single-End-Kontaktelemente 13a Signale bzw. Informationen jeweils nur über einen einzelnen elektrischen Leiter übertragen, so werden bei den Differential-Pair-Kontaktelementen 13b jeweils zwei elektrische Leiter verwendet, um ein Differenzsignal dieser beiden Leiter zu übertragen. Einige der Power-Kontaktelemente 13c sind im gezeigten Ausführungsbeispiel ähnlich wie die Differential-Pair-Kontaktelemente 13b jeweils paarweise ausgeführt, während andere als 3er-Kontakt ausgeführt sind. Die Power-Kontaktelemente 13c dienen zur Leistungsübertragung.

Das rechnerseitige Verbinderelement 10 weist ein rechnerseitiges Gehäuse 20 mit einer Mehrzahl von rechnerseitigen Kontakthohlräumen 11a, 11b, und 11c auf, nämlich einem rechnerseitigen Single-Pair-Kontakthohlraum 11a, einer Mehrzahl (hier genau 48) von rechnerseitigen Differential-Pair-Kontakthohlräumen 11b und einem rechnerseitigen Power-Kontakthohlraum 11c. Sämtliche Kontakthohlräume 11a-11c sind durch das rechnerseitige Gehäuse 20 hindurch verlaufend ausgebildet und durchdringen somit das rechnerseitige Gehäuse 20 vollständig. Die Kontakthohlräume 11a-11c weisen (in erster Montagerichtung M1, siehe unten) einen etwa konstanten Querschnitt auf, welcher z.B. etwa rechteckig ausgebildet ist.

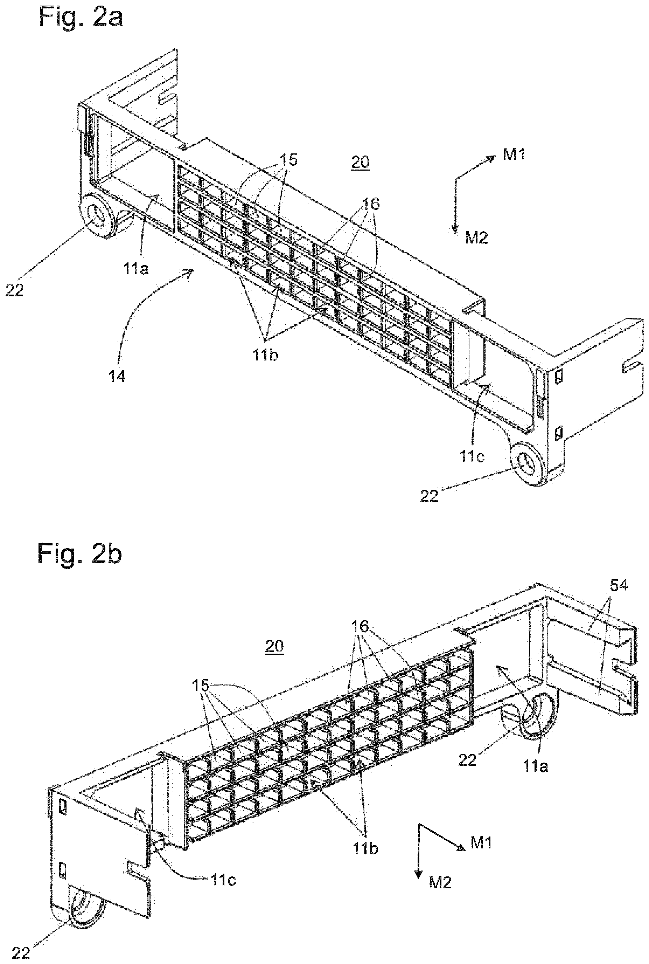

Das rechnerseitige Gehäuse 20 weist eine Vielzahl von rechnerseitigen Abschirmelementen 15, 16 (siehe Figur 2b) auf, welche die rechnerseitigen Differential-Pair Kontakthohlräume 11b des rechnerseitigen Gehäuses 20 ausbilden. Entsprechend weist das kartenseitige Gehäuse 40 eine Vielzahl von kartenseitigen Abschirmelementen 35, 36 auf, welche die kartenseitigen Differential-Pair Kontakthohlräume 31b des kartenseitigen Gehäuses 40 ausbilden. Die rechnerseitigen Abschirmelemente 15, 16 weisen Endabschnitte auf, welche im montierten Zustand jeweils mit zugehörigen Endabschnitten der kartenseitigen Abschirmelemente 35, 36 überlappen. Beim Zusammenstecken des rechnerseitigen Verbinderelements 10 mit dem kartenseitigen Verbinderelement 30 dringen somit die rechnerseitigen Abschirmelemente 15, 16 in die kartenseitigen Differential-Pair Kontakthohlräume 31b ein, während die kartenseitigen Abschirmelemente 35, 36 in die rechnerseitigen Differential-Pair Kontakthohlräume 11b eindringen.

Ferner weist das rechnerseitige Verbinderelement 10 eine Mehrzahl von rechnerseitigen Isolierkörpern 12a, 12b und 12c auf, welche jeweils zumindest einen Isolierraum ausbilden und umschließen, der durch das rechnerseitige Gehäuse 20 hindurch verlaufend ausgebildet ist.

Die Isolierkörper 12a, 12b und 12c sind innerhalb der rechnerseitigen Kontakthohlräume 11a-11c angeordnet. Im gezeigten Ausführungsbeispiel weist das rechnerseitige Verbinderelement 10 einen rechnerseitigen Single-Pair-Isolierkörper 12a auf, eine Mehrzahl (hier genau 48) von rechnerseitigen Differential-Pair-Isolierkörper 12b und einen rechnerseitigen Power-Isolierkörper 12c.

Die rechnerseitigen Kontaktelemente 13a-13c sind im montierten Zustand zumindest bereichsweise innerhalb von rechnerseitigen Isolierhohlräumen der jeweils zugehörigen rechnerseitigen Isolierkörper 12a-12c angeordnet. So sind die Single-End-Kontaktelemente 13a im Single-End-Kontakthohlraum 11a und innerhalb von Isolierhohlräumen des Single-End-Isolierkörpers 12a angeordnet. Die Differential-Pair-Kontaktelemente 13b sind jeweils in zugehörigen Differential-Pair-Kontakthohlräumen 11b und innerhalb von zugehörigen Isolierhohlräumen der Differential-Pair-Isolierkörper 12b angeordnet. Die Power-Kontaktelemente 13c sind in dem Power-Kontakthohlraum 11c und jeweils innerhalb von zugehörigen Isolierhohlräumen des Power-Isolierkörpers 12c angeordnet.

Das rechnerseitige Gehäuse 20 weist zumindest eine Schrauböffnung 22 auf, im gezeigten Ausführungsbeispiel genau zwei Schrauböffnungen 22. Jede Schrauböffnung 22 ist einstückig mit dem Gehäuse 20 als Zinkdruckgussbauteil ausgebildet. Die Schrauböffnungen 22 sind an einem Rand der rechnerseitigen Steckseite 14 des rechnerseitigen Gehäuses 20 ausgebildet. Dabei weist jede Schrauböffnung 22 eine kreisförmige Umrandung auf, welche einen Hohlzylinderabschnitt umgibt, in welchen eine Schraube eingeschraubt werden kann. Die Zylinderachse des Hohlzylinderabschnitts ist etwa parallel zur ersten Montagerichtung M1 und/oder zu den kartenseitigen Kontaktelementen 13a-13c angeordnet. Somit kann das rechnerseitige Gehäuse 20 mittels in die Schrauböffnungen 22 geschraubte Schrauben an dem (nicht gezeigten) Zentralrechner befestigt werden. Dabei werden die Schrauben in etwa parallel zu den rechnerseitigen Kontaktelementen 13a-13c durch die Schrauböffnungen geschraubt. Dadurch wird die Befestigung des rechnerseitigen Verbinderelements 10 am Zentralrechner verstärkt und/oder gesichert.

Das kartenseitige Verbinderelement 30 ist ausgelegt, um mit einer PCB-Karte entlang einer zweiten Montagerichtung M2 verbunden zu werden. Dazu weist das kartenseitige Verbinderelement 30 auf seiner Unterseite, der kartenseitigen Steckseite 34, rechnerseitigen Kontaktelementen 13a-13c entsprechende kartenseitige Kontaktelemente (in Figur 1 nicht gezeigt) auf. Dabei sind die kartenseitigen Kontaktelemente etwa rechtwinklig ausgebildet mit einem ersten Abschnitt, der sich etwa parallel zur ersten Montagerichtung M1 erstreckt, und einem zweiten Abschnitt, der sich etwa parallel zur zweiten Montagerichtung M2 erstreckt. Der zweite Abschnitt der kartenseitigen Kontaktelemente kann hierbei aus der kartenseitigen Steckseite 34 herausragen zum (elektrischen und/oder physikalischen) kontaktieren der PCB-Karte.

Wie in der Figur 1 gezeigt, ist die zweite Montagerichtung M2 im Wesentlichen senkrecht zur ersten Montagerichtung M1 ausgerichtet. Das kartenseitige Verbinderelement 30 ist dazu ausgebildet und vorgesehen, mit seiner kartenseitigen Steckseite 34 voran in Richtung der zweiten Montagerichtung M2 an der (nicht gezeigten) PCB-Karte befestigt, z.B. verlötet, zu werden. Die kartenseitige Steckseite 34 ist im montierten Zustand in einer Ebene angeordnet, die etwa senkrecht zu der Ebene angeordnet ist, in der die rechnerseitige Steckseite 14 angeordnet ist.

Das kartenseitige Verbinderelement 30 weist ein kartenseitiges Gehäuse 40 mit einer Mehrzahl von kartenseitigen Kontakthohlräumen 31a-31c auf. Dabei kann das kartenseitige Gehäuse 40 einstückig ausgebildet sein oder auch zwei kartenseitige Gehäuseelemente aufweisen, welche miteinander verbunden bzw. zusammengesteckt werden können.

Das kartenseitige Gehäuse 40 weist eine Mehrzahl von kartenseitigen Isolierkörpern 32a-32c auf, welche im montierten Zustand innerhalb der kartenseitigen Kontakthohlräume 31a-31c angeordnet sind. Die kartenseitigen Isolierkörper 32a-32c wiederum weisen kartenseitige Isolierhohlräume auf, die ausgelegt sind, um im montierten Zustand zugehörige rechnerseitige Kontaktelemente 13a-13c zumindest bereichsweise aufzunehmen. Sowohl die kartenseitigen Kontakthohlräume 31a-31c, die kartenseitigen Isolierkörper 32a-32c, als auch die kartenseitigen Kontaktelemente sind winklig ausgebildet. Die kartenseitigen Kontakthohlräume 31a-31c usw. weisen dabei einen ersten Abschnitt auf, welcher etwa parallel zur ersten Montagerichtung M1 ausgebildet ist, und einen zweiten Abschnitt, welcher etwa parallel zur zweiten Montagerichtung M2 ausgebildet ist.

Im gezeigten Ausführungsbeispiel weist das kartenseitige Verbinderelement 30 einen kartenseitigen Single-Pair-Isolierkörper 32a, eine Mehrzahl (hier genau 48) von kartenseitigen Differential-Pair-Isolierkörper 32b (in der Figur 1 nicht ersichtlich) und einen kartenseitigen Power-Isolierkörper 32c auf. Die kartenseitigen Kontaktelemente (in Figur 1 nicht ersichtlich) sind im montierten Zustand zumindest bereichsweise innerhalb von kartenseitigen Isolierhohlräumen der jeweils zugehörigen kartenseitigen Isolierkörper 32a-32c angeordnet. So sind Single-End-Kontaktelemente im Single-End-Kontakthohlraum 31a und innerhalb von Isolierhohlräumen des Single-End-Isolierkörpers 32a angeordnet. Differential-Pair-Kontaktelemente sind jeweils in zugehörigen Differential-Pair-Kontakthohlräumen 31b und innerhalb von zugehörigen Isolierhohlräumen der Differential-Pair-Isolierkörper 32b angeordnet. Power-Kontaktelemente sind in dem Power-Kontakthohlraum 31c und innerhalb von zugehörigen Isolierhohlräumen des Power-Isolierkörpers 32c angeordnet.

Im montierten Zustand, in dem das rechnerseitige Verbinderelement 10 mit dem kartenseitigen Verbinderelement 30 verbunden und/oder zusammengesteckt ist, kontaktieren sich die rechnerseitigen Kontaktelemente 13a-13c und die kartenseitigen Kontaktelemente in den kartenseitigen Kontakthohlräumen 31a-31c und in den Isolierhohlräumen der kartenseitigen Isolierkörper 32a-32c. Zudem überlappen die rechnerseitigen Abschirmelemente 15, 16 mit den kartenseitigen Abschirmelementen 35, 36, so dass mittels dieser Abschirmelemente im montierten Zustand eine durchgehende Schirmung der rechnerseitigen Differential-Pair Kontaktelemente 13b und der kartenseitigen Kontaktelemente 31b erfolgt. Vorteilhafterweise liegt ein Überlapp der Abschirmelemente und damit die Schirmwirkung nicht nur im vollständig zusammengesteckten bzw. montierten Zustand vor, sondern schon während des Schließens bzw. auch noch während des Öffnens der Verbindung zwischen dem rechnerseitigen Verbinderelement 10 und dem kartenseitigen Verbinderelement 30.

Das rechnerseitige Gehäuse 20 kann ferner eine Mehrzahl von Stabilisierungselementen aufweisen, während das kartenseitige Gehäuse 40 eine entsprechende Anzahl von komplementären Stabilisierungselementen aufweisen kann. Beim Zusammenstecken des rechnerseitigen Verbinderelements 10 und des kartenseitigen Verbinderelements 30 greifen die Stabilisierungselemente ineinander ein und stabilisieren die Steckverbindung im montierten Zustand. Zusätzlich können die Stabilisierungselemente auch als Steckhilfe dienen.

Das kartenseitige Gehäuse 40 weist zudem zumindest ein Führungselement 52, z.B. einen Vorsprung, auf, welcher beim Zusammenstecken des rechnerseitigen Verbinderelements 10 und des kartenseitigen Verbinderelements 30 in ein komplementäres Führungselement 54 des rechnerseitigen Gehäuses 10 eingreift. Dabei kann eines der Führungselemente 52 länglich ausgebildet sein, etwa parallel zur ersten Montagerichtung M1 ausgerichtet sein und/oder sich in Richtung zum zugeordneten Verbinderelement 10 bzw. 30 hin verjüngend ausgebildet sein. Dies erleichtert das Ausrichten des rechnerseitigen und kartenseitigen Verbinderelements 10 und 30 beim Zusammenstecken und somit die Montage des Verbindersystems 100.

Ferner kann das kartenseitige Gehäuse 40 ein Federelement aufweisen, welches das kartenseitige Gehäuse 40 elektrisch kontaktiert und welches ausgelegt ist, um im montierten Zustand auch das rechnerseitige Gehäuse 20 elektrisch zu kontaktieren. Somit besteht ein elektrischer Kurzschluss zwischen den beiden Gehäusen 20 und 40, was die Schirmung der Kontaktelemente und damit die Signalqualität weiter verbessert.

Das rechnerseitige Verbinderelement 10 und das kartenseitige Verbinderelement 30 können z.B. eine Länge (etwa senkrecht zu den beiden Montagerichtungen M1 und M2) von etwa 85 mm, eine Tiefe (etwa parallel zur ersten Montagerichtung M1) von etwa 15 mm und eine Höhe (etwa parallel zur zweiten Montagerichtung M2) von etwa 12 mm aufweisen. Diese Abmessungen sind lediglich beispielhaft für den Automotive-Bereich und können je nach Anwendung auch andere für den Automotive Bereich geeignete Dimensionen einnehmen.

Die **Figur 2A** zeigt in einer ersten perspektivischen Ansicht (schräge Vorderansicht) eine schematische Skizze des rechnerseitigen Gehäuses 20 des in Figur 1 gezeigten Verbindersystems 100, während die **Figur 2B** das rechnerseitige Gehäuse 20 in einer zweiten perspektivischen Ansicht (schräge Rückansicht) zeigt. In den Figuren 2A und 2B sind nochmals die Kontakthohlräume 11a-11c gezeigt, welche das rechnerseitige Gehäuse 20 vollständig durchdringen und einen etwa rechteckigen Querschnitt aufweisen.

Wie in den Figuren 2A und 2B gezeigt, weist insbesondere jeder einzelne der von den Abschirmelementen 15, 16 ausgebildeten Kontakthohlräume 11b einen etwa rechteckigen Querschnitt auf zum drehfesten Aufnehmen der Differential-Pair-Isolierkörper 12b. Beim Zusammenstecken des rechnerseitigen Verbinderelements 10 und des kartenseitigen Verbinderelements 30, und schließlich im montierten Zustand, werden von den rechnerseitigen Kontakthohlräume 11a-11c und den kartenseitigen Kontakthohlräume 31a-31c zusammen durchgängige Kanäle und/oder Hohlräume für die Kontaktelemente ausgebildet. Diese durchgängigen Kanäle resultieren aus dem Überlapp der rechnerseitigen Abschirmelemente 15, 16 mit den zugehörigen kartenseitigen Abschirmelementen 35, 36. Im montierten Zustand sind die beiden Gehäuse 20 und 40 somit aneinander gekoppelt und/oder elektrisch kontaktiert, was eine gute Schirmung gewährleistet.

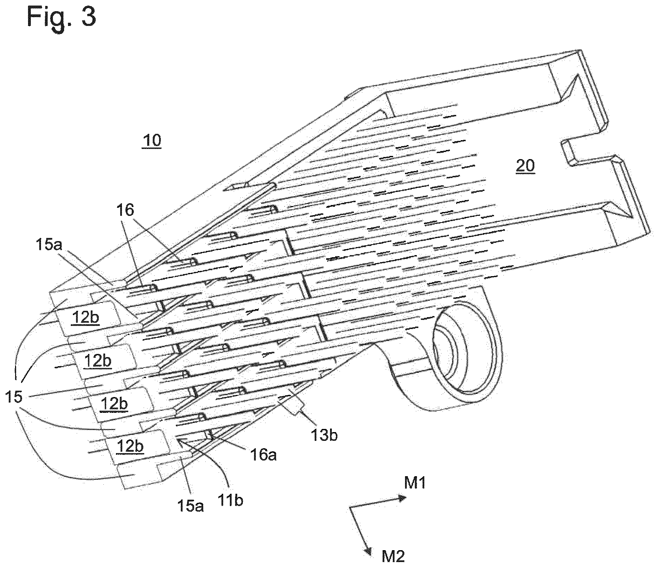

Die **Figur 3** zeigt in einer perspektivischen Ansicht (Rückansicht) einen Schnitt durch das rechnerseitige Verbinderelement 10. Die horizontal, d.h. entlang der ersten Montagerichtung, angeordneten rechnerseitigen Abschirmelemente 15 weisen jeweils einen verjüngten Endabschnitt 15a auf. Ferner weist das Gehäuse 20 vertikale Abschirmelemente 16 auf, die entlang der zweiten Montagerichtung jeweils zwischen den horizontalen Abschirmelementen 15 angeordnet sind. Durch die horizontalen und vertikalen Abschirmelemente 15, 16 werden die Differential-Pair Kontaktöffnungen 11b (siehe die Figuren 1 und 2a) ausgebildet. In Figur 3 sind insbesondere auch die Querschnitte der rechnerseitigen Abschirmelemente 15 und 16 sichtbar. Während der Querschnitt der horizontalen Abschirmelemente 15 L-förmig ist, so haben die vertikalen Abschirmelemente 16 einen rechteckigen Querschnitt. Ferner sind in Figur 3 die rechnerseitigen Differential-Pair Isolierkörper 12b sowie die darin angeordneten Differential-Pair Kontaktelemente bzw. Kontaktelementpaare 13b erkennbar.

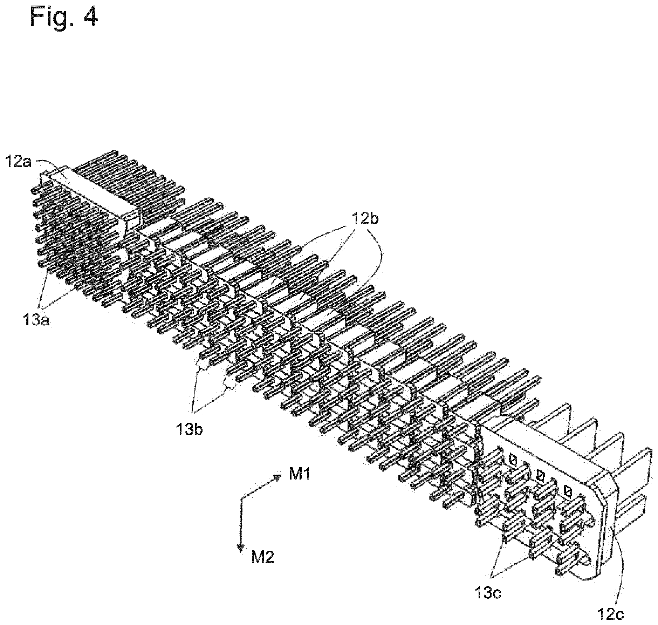

Die **Figur 4** zeigt eine schematische Skizze des rechnerseitigen Verbinderelements 10 aus Figur 1. Im Vergleich zur Figur 1 wurde in der Figur 3 z.B. das rechnerseitige Gehäuse 20 ausgeblendet, so dass die rechnerseitigen Isolierkörper 12a-12c und die rechnerseitigen Kontaktelemente 13a-13c besser gezeigt sind. Insbesondere ist in Figur 4 gezeigt, dass die hohlförmigen Isolierkörper 12a-12c die Kontaktelemente 13a-13c zumindest bereichsweise umgeben. Mit anderen Worten sind die Kontaktelemente 13a-13c zumindest bereichsweise innerhalb von Hohlräumen der Isolierkörper 12a-12c angeordnet.

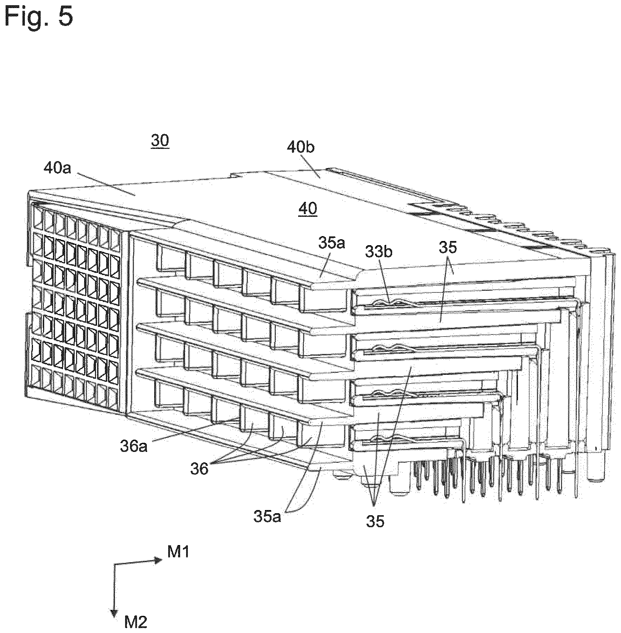

Die **Figur 5** zeigt in einer perspektivischen Vorderansicht einen Schnitt durch das rechnerseitige Verbinderelement 30. Die horizontal, d.h. entlang der ersten Montagerichtung, angeordneten kartenseitigen Abschirmelemente 35 weisen jeweils einen verjüngten Endabschnitt 35a auf. Das kartenseitige Gehäuse 40 umfasst in der gezeigten Ausführungsform ein erstes kartenseitiges Gehäuseelement 40a und ein zweiten kartenseitiges Gehäuseelement 40b. Das kartenseitige Gehäuse 40 bzw. das erste kartenseitige Gehäuseelement 40a weist vertikale kartenseitige Abschirmelemente 36 auf, die entlang der zweiten Montagerichtung M2 jeweils zwischen den horizontalen kartenseitigen Abschirmelementen 35 angeordnet sind. Durch die horizontalen und vertikalen kartenseitigen Abschirmelemente 35, 36 werden die kartenseitigen Differential-Pair Kontaktöffnungen 31b (siehe Figur 1) ausgebildet.

Ferner sind in Figur 5 kartenseitige Differential-Pair Kontaktelemente 33b erkennbar, welche einen wellenförmigen Endabschnitt mit zwei Kontaktpunkten (die beiden Maxima der wellenförmigen Endabschnitte) aufweisen, um bei einem Überlapp mit einem rechnerseitigen Differential-Pair Kontaktelement 33b das rechnerseitige Differential-Pair Kontaktelement 33b an zumindest zwei unterschiedlichen Kontaktstellen elektrisch zu kontaktieren.

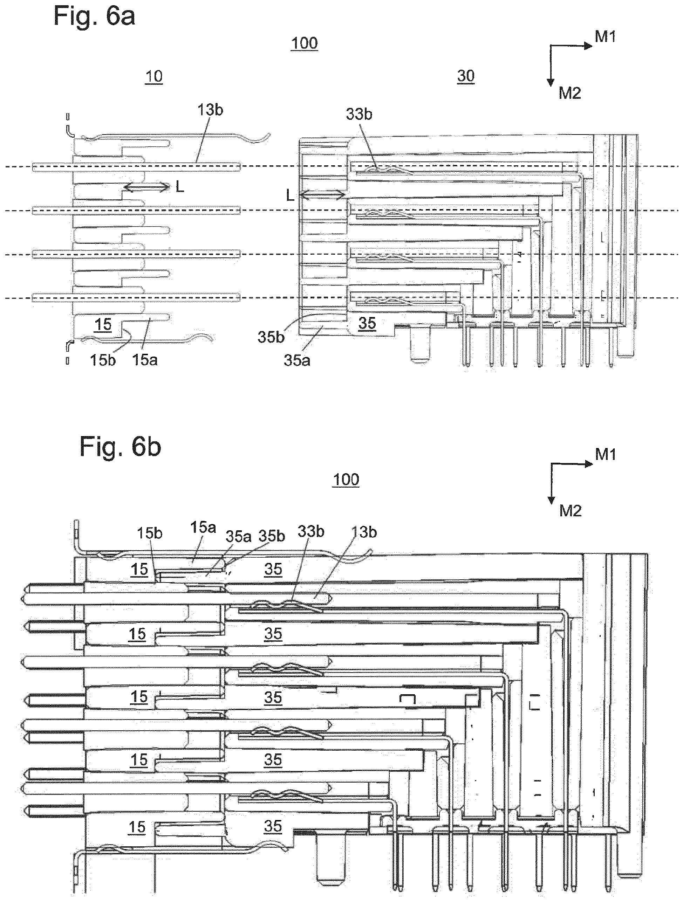

Die **Figur 6a** zeigt in einer Seitenansicht einen Schnitt durch das rechnerseitige Verbinderelement 10 und das kartenseitige Verbinderelement 30 im demontierten, d.h. im nicht zusammengesteckten, Zustand. Die beiden Verbinderelemente 10 und 30 sind entlang der eingezeichneten gestrichelten Linien, d.h. entlang der ersten Montagerichtung M1 zusammensteckbar. Das in der Figur 6a gezeigte linke Ende des rechnerseitigen Verbinderlements 10 kann mit einem KFZ-Zentralrechner (nicht gezeigt) verbunden werden. Ferner kann das in der Figur 6a gezeigte untere Ende des kartenseitigen Verbinderelements 30 entlang der zweiten Montagerichtung M2 mit einer PCB-Karte (nicht gezeigt) verbunden werden.

Einige der rechnerseitigen Abschirmelemente, nämlich die rechnerseitigen horizontalen Abschirmelemente 15, weisen rechnerseitige Anschlagabschnitte 15b auf, welche ein Eindringen der kartenseitigen Endabschnitte 35a von jeweils zugehörigen kartenseitigen Abschirmelementen 35 in das rechnerseitige Verbinderelement 10 begrenzen. Ferner weisen die kartenseitigen horizontalen Abschirmelemente 35 kartenseitige Anschlagabschnitte 35b auf, welche ein Eindringen der rechnerseitigen Endabschnitte 15a von jeweils zugehörigen rechnerseitigen Abschirmelementen 15 in das kartenseitige Verbinderelement 30 begrenzen. Die rechnerseitigen Anschlagabschnitte 15b stellen jeweils eine Kante der verjüngten Endabschnitte 15a der rechnerseitigen Abschirmelemente 15 dar. Und die kartenseitigen Anschlagabschnitte 35b stellen jeweils eine Kante der verjüngten Endabschnitte 35a der kartenseitigen Abschirmelemente 35 dar.

Die rechnerseitigen Endabschnitte 15a der rechnerseitigen horizontalen Abschirmelemente 15 und die kartenseitigen Endabschnitte 35a der kartenseitigen horizontalen Abschirmelemente 35 weisen eine im Wesentlichen gleiche Länge L auf. Diese Länge L ist derart gewählt, dass sich bei einem Zusammenstecken des rechnerseitigen Verbinderelements 10 und des kartenseitigen Verbinderelements 30 die rechnerseitigen Endabschnitte 15a und die kartenseitigen Endabschnitte 35a bereits überlappen noch bevor sich die rechnerseitigen Differential-Pair Kontaktelemente 13b und die kartenseitigen Differential-Pair Kontaktelemente 33b vollständig, d.h. mit beiden vorgesehenen Kontaktstellen der wellenförmigen Endabschnitte der kartenförmigen Differential-Pair Kontaktelemente 33b berühren bzw. kontaktieren. Die Länge L der rechnerseitigen und/oder kartenseitigen Endabschnitte 15a, 35a ist ferner derart gewählt, dass im montierten Zustand die kartenseitigen und rechnerseitigen Differential-Pair Kontaktelemente 13b und 33b derart überlappen, dass sie sich an den zumindest zwei vorgesehenen Kontaktstellen kontaktieren (siehe Figur 6b).

Wie in Figur 6a weiter erkennbar ist, ragen die rechnerseitigen Differential-Pair Kontaktelemente 13b entlang der ersten Montagerichtung M1 über die rechnerseitigen Abschirmelemente 15 hinaus, während die kartenseitigen Abschirmelemente 35 entlang der ersten Montagerichtung M1 über die kartenseitigen Differential-Pair Kontaktelemente 33b hinausragen. Dies führt dazu, dass im montierten Zustand der Kontakt zwischen den rechnerseitigen Differential-Pair Kontaktelementen 13b und den kartenseitigen Differential-Pair Kontaktelementen 33b innerhalb des kartenseitigen Verbinderelements 30 bzw. innerhalb der kartenseitigen Differential-Pair Kontakthohlräume 31b zustande kommt.

Die **Figur 6b** zeigt in der Seitenansicht von Figur 6a einen Schnitt durch das Verbindersystem 100 im montierten bzw. zusammengesteckten Zustand. Hierbei ist erkennbar, dass sich die Endabschnitte 15a der rechnerseitigen Abschirmelemente 15 und die jeweils zugehörigen komplementären Endabschnitte 35a der kartenseitigen Abschirmelemente 35 im montierten Zustand formschlüssig überlappen. Zudem grenzen die Endabschnitte 15a der rechnerseitigen Abschirmelemente 15 an die Anschlagabschnitte 35b der kartenseitigen Abschirmelemente 35 an bzw. berühren und kontaktieren diese. Entsprechend grenzen die Endabschnitte 35a der kartenseitigen Abschirmelemente 35 an die Anschlagabschnitte 15b der rechnerseitigen Abschirmelemente 35 an bzw. berühren und kontaktieren diese.

### Bezugszeichenliste

- 10: rechnerseitiges Verbinderelement
- 11: rechnerseitige Kontakthohlräume
- 11a: rechnerseitiger Single-End Kontakthohlraum
- 11b: rechnerseitiger Differential-Pair Kontakthohlraum
- 11c: rechnerseitiger Power Kontakthohlraum
- 12: rechnerseitige Isolierkörper / rechnerseitiges Isolierelement
- 12a: rechnerseitiger Single-End Isolierkörper
- 12b: rechnerseitiger Differential-Pair Isolierkörper
- 12c: rechnerseitiger Power Isolierkörper
- 13: rechnerseitige Kontaktelemente
- 13a: rechnerseitiges Single-End Kontaktelement
- 13b: rechnerseitiges Differential-Pair Kontaktelement bzw. Kontaktelementpaar
- 13c: rechnerseitiges Power Kontaktelement
- 14: rechnerseitige Steckseite
- 15: rechnerseitiges (horizontales) Abschirmelement
- 15a: rechnerseitiger Endabschnitt
- 15b: rechnerseitiger Anschlagabschnitt
- 16: rechnerseitiges (vertikales) Abschirmelement
- 16a: rechnerseitiger Endabschnitt
- 20: rechnerseitiges Gehäuse / Zinkdruckguss-Gehäuse
- 22: Schrauböffnung
- 30: kartenseitiges Verbinderelement
- 31: kartenseitige Kontakthohlräume
- 31a: kartenseitiger Single-End Kontakthohlraum
- 31b: kartenseitiger Differential-Pair Kontakthohlraum
- 31c: kartenseitiger Power Kontakthohlraum
- 32: kartenseitige Isolierkörper / kartenseitiges Isolierelement
- 32a: kartenseitiger Single-End Isolierkörper
- 32b: kartenseitiger Differential-Pair Isolierkörper
- 32c: kartenseitiger Power Isolierkörper
- 33: kartenseitige Kontaktelemente
- 33a: kartenseitiges Single-End Kontaktelement
- 33b: kartenseitiges Differential-Pair Kontaktelement bzw. Kontaktelementpaar
- 33c: kartenseitiges Power Kontaktelement
- 34: kartenseitige Steckseite
- 35: kartenseitiges (horizontales) Abschirmelement
- 35a: kartenseitiger Endabschnitt
- 35b: kartenseitiger Anschlagabschnitt
- 36: kartenseitiges (vertikales) Abschirmelement
- 36a: kartenseitiger Endabschnitt
- 40: kartenseitiges Gehäuse / Zinkdruckguss-Gehäuse
- 40a: erstes kartenseitiges Gehäuseelement
- 40b: zweites kartenseitiges Gehäuseelement
- 52: Führungselement
- 54: komplementäres Führungselement
- 80: elektrischer Leiter / Leiterbahn
- 90: steckseitiger Rand / steckseitige Fläche
- 100: Verbindersystem
- L: Länge
- M1: erste Montagerichtung
- M2: zweite Montagerichtung

## Patentansprüche

1. Rechnerseitiges Verbinderelement (10) für ein Verbindersystem (100) zum Verbinden einer PCB-Karte mit einem Zentralrechner eines Kraftfahrzeugs, aufweisend ein rechnerseitiges Gehäuse (20), welches eine Vielzahl von rechnerseitigen Abschirmelementen (15, 16) aufweist, welche vorgesehen und angeordnet sind, um eine Vielzahl von rechnerseitigen Kontakthohlräumen (31b) des rechnerseitigen Gehäuses (20) auszubilden, wobei die rechnerseitigen Abschirmelemente (15, 16) Endabschnitte (15a, 16a) aufweisen, welche vorgesehen und angeordnet sind, um im montierten Zustand mit jeweils zugehörigen Endabschnitten (35a, 36a) von kartenseitigen Abschirmelementen (35, 36) eines kartenseitigen Verbinderelements (10) zu überlappen;
**dadurch gekennzeichnet, dass**
die Gesamtheit der rechnerseitigen Abschirmelemente (15, 16) aus einem einzigen Gehäusestück des rechnerseitigen Gehäuses (20) ausgebildet ist.

2. Kartenseitiges Verbinderelement (30) für ein Verbindersystem (100) zum Verbinden einer PCB-Karte mit einem Zentralrechner eines Kraftfahrzeugs, aufweisend ein kartenseitiges Gehäuse (40), welches eine Vielzahl von kartenseitigen Abschirmelementen (35, 36) aufweist, welche vorgesehen und angeordnet sind, um eine Vielzahl von kartenseitigen Kontakthohlräumen (31b) des kartenseitigen Gehäuses (40) - auszubilden, wobei die kartenseitigen Abschirmelemente (35, 36) Endabschnitte (35a, 36a) aufweisen, welche vorgesehen und angeordnet sind, um im montierten Zustand mit jeweils zugehörigen Endabschnitten (15a, 16a) von rechnerseitigen Abschirmelementen (15, 16) eines rechnerseitigen Verbinderelements (10) zu überlappen;
**dadurch gekennzeichnet, dass**
die Gesamtheit der kartenseitigen Abschirmelemente (35, 36) aus einem einzigen Gehäusestück des kartenseitigen Gehäuses (40) ausgebildet ist.

3. Verbindersystem (100) zum Verbinden einer PCB-Karte mit einem Zentralrechner eines Kraftfahrzeugs, aufweisend ein rechnerseitiges Verbinderelement (10) gemäß Anspruch 1 und ein kartenseitiges Verbinderelement (30) gemäß Anspruch 2.

4. Verbindersystem (100) nach Anspruch 3,
wobei die rechnerseitigen Abschirmelemente (15, 16) als Begrenzungselemente der rechnerseitigen Kontakthohlräume (11b) ausgebildet sind, und/oder
wobei die kartenseitigen Abschirmelemente (35, 36) als Begrenzungselemente der kartenseitigen Kontakthohlräume (31b) ausgebildet sind.

5. Verbindersystem (100) nach einem der Ansprüche 3 und 4, wobei sich die Endabschnitte (15a, 16a) der rechnerseitigen Abschirmelemente (15, 16) und die jeweils zugehörigen komplementären Endabschnitte (35a, 36a) der kartenseitigen Abschirmelemente (35, 36) im montierten Zustand formschlüssig überlappen.

6. Verbindersystem (100) nach Anspruch 5, wobei zumindest einige (15a) der Endabschnitte (15a, 16a) der rechnerseitigen Abschirmelemente (15, 16) jeweils als Verjüngung der rechnerseitigen Abschirmelemente (15) ausgebildet sind, und/oder wobei zumindest einige (35a) der Endabschnitte (35a, 36a) der kartenseitigen Abschirmelemente (35, 36) jeweils als Verjüngung der kartenseitigen Abschirmelemente (35) ausgebildet sind.

7. Verbindersystem (100) nach einem der Ansprüche 3 bis 6,
wobei zumindest einige (15) der rechnerseitigen Abschirmelemente (15, 16) rechnerseitige Anschlagabschnitte (15b) aufweisen, welche ein Eindringen der kartenseitigen Endabschnitte (35a) von jeweils zugehörigen kartenseitigen Abschirmelementen (35) in das rechnerseitige Verbinderelement (10) begrenzen, und/oder
wobei zumindest einige (35) der kartenseitigen Abschirmelemente (35, 36) kartenseitige Anschlagabschnitte (35b) aufweisen, welche ein Eindringen der rechnerseitigen Endabschnitte (15a) von jeweils zugehörigen rechnerseitigen Abschirmelementen (15) in das kartenseitige Verbinderelement (30) begrenzen.

8. Verbindersystem (100) nach einem der Ansprüche 3 bis 7, wobei das rechnerseitige Verbinderelement (10) ausgelegt ist, um entlang einer ersten Montagerichtung (M1) mit dem Zentralrechner verbunden zu werden, wobei das kartenseitige Verbinderelement (30) ausgelegt ist, um entlang einer zweiten Montagerichtung (M2) mit der PCB-Karte verbunden zu werden, und wobei das rechnerseitige Verbinderelement (10) und das kartenseitige Verbinderelement (30) entlang der ersten Montagerichtung (M1) zusammensteckbar sind.

9. Verbindersystem (100) nach einem der Ansprüche 3 bis 8,
wobei das rechnerseitige Verbinderelement (10) eine Vielzahl von rechnerseitigen Differential-Pair Kontaktelementpaaren (13b) aufweist, wobei jedes rechnerseitige Differential-Pair Kontaktelementpaar (13b) in einem der von den rechnerseitigen Abschirmelementen (15, 16) ausgebildeten rechnerseitigen Kontakthohlräumen (11b) zumindest bereichsweise angeordnet ist, und
wobei das kartenseitige Verbinderelement (30) eine Vielzahl von kartenseitigen Differential-Pair Kontaktelementpaaren (33b) aufweist, wobei jedes kartenseitige Differential-Pair Kontaktelementpaar (33b) in einem der von den kartenseitigen Abschirmelementen (35, 36) ausgebildeten kartenseitigen Kontakthohlräumen (31b) zumindest bereichsweise angeordnet ist.

10. Verbindersystem (100) nach einem der Ansprüche 3 bis 9, wobei die rechnerseitigen Endabschnitte (15a, 16a) der rechnerseitigen Abschirmelemente (15, 16) und die kartenseitigen Endabschnitte (35a, 36a) der kartenseitigen Abschirmelemente (35, 36) eine im Wesentlichen gleiche Länge (L) aufweisen.

11. Verbindersystem (100) nach Anspruch 10 in Verbindung mit Anspruch 9, wobei die Länge (L) derart gewählt ist, dass sich bei einem Zusammenstecken des rechnerseitigen Verbinderelements (10) und des kartenseitigen Verbinderelements (30) die rechnerseitigen Endabschnitte (15a, 16a) und die kartenseitigen Endabschnitte (35a, 36a) bereits überlappen noch bevor sich die rechnerseitigen Differential-Pair Kontaktelementpaare (13b) und die kartenseitigen Differential-Pair Kontaktelementpaare (33b) vollständig kontaktieren.

12. Verbindersystem (100) nach Anspruch 10 oder 11, wobei die kartenseitigen Differential-Pair Kontaktelemente (13b) wellenförmige Endabschnitte aufweisen, um bei einem Überlapp mit einem rechnerseitigen Differential-Pair Kontaktelement (33b) das rechnerseitige Differential-Pair Kontaktelement (33b) an zumindest zwei unterschiedlichen Kontaktstellen elektrisch zu kontaktieren, und wobei die Länge (L) der rechnerseitigen und/oder kartenseitigen Endabschnitte derart gewählt ist, dass im montierten Zustand die kartenseitigen und rechnerseitigen Differential-Pair Kontaktelemente (13b, 33b) derart überlappen, dass sie sich an den zumindest zwei vorgesehenen Kontaktstellen kontaktieren.

13. Verbindersystem (100) nach einem der Ansprüche 9 bis 12,
wobei die rechnerseitigen Differential-Pair Kontaktelementpaare (13b) über die rechnerseitigen Abschirmelemente (15, 16) hinausragen, und/oder
wobei die kartenseitigen Abschirmelemente (35, 36) über die kartenseitigen Differential-Pair Kontaktelementpaare (33b) hinausragen.

14. Verbindersystem (100) nach einem der Ansprüche 3 bis 13, wobei das rechnerseitige Gehäuse (20) und das kartenseitige Gehäuse (40) jeweils aus Zinkdruckguss gefertigt sind.

## Claims

1. A computer-side connector element (10) for a connector system (100) for connecting a PCB card to a central computer of a motor vehicle, having a computer-side housing (20) which has a plurality of computer-side shielding elements (15, 16) which are provided and arranged to form a plurality of computer-side contact cavities (31b) of the computer-side housing (20), wherein the computer-side shielding elements (15, 16) have end portions (15a, 16a) which are provided and arranged to overlap in the mounted state with associated end portions (35a, 36a) of card-side shielding elements (35, 36) of a card-side connector element (10);
**characterized in that**
the entirety of the computer-side shielding elements (15, 16) is formed from a single housing piece of the computer-side housing (20).

2. A card-side connector element (30) for a connector system (100) for connecting a PCB card to a central computer of a motor vehicle, having a card-side housing (40) which has a plurality of card-side shielding elements (35, 36) which are provided and arranged to form a plurality of card-side contact cavities (31b) of the card-side housing (40), wherein the card-side shielding elements (35, 36) have end portions (35a, 36a) which are provided and arranged to overlap in the mounted state with associated end portions (15a, 16a) of computer-side shielding elements (15, 16) of a computer-side connector element (10);
**characterized in that**
the entirety of the card-side shielding elements (35, 36) is formed from a single housing piece of the card-side housing (40).

3. A connector system (100) for connecting a PCB card to a central computer of a motor vehicle, having a computer-side connector element (10) according to claim 1 and a card-side connector element (30) according to claim 2.

4. The connector system (100) according to claim 3,
wherein the computer-side shielding elements (15, 16) are formed as limiting elements of the computer-side contact cavities (11b), and/or
wherein the card-side shielding elements (35, 36) are formed as limiting elements of the card-side contact cavities (31b).

5. The connector system (100) according to one of claims 3 and 4, wherein the end portions (15a, 16a) of the computer-side shielding elements (15, 16) and the associated complementary end portions (35a, 36a) of the card-side shielding elements (35, 36) overlap in a positive-locking manner in the mounted state.

6. The connector system (100) according to claim 5, wherein at least some (15a) of the end portions (15a, 16a) of the computer-side shielding elements (15, 16) are each formed as a narrowing of the computer-side shielding elements (15), and/or wherein at least some (35a) of the end portions (35a, 36a) of the card-side shielding elements (35, 36) are each formed as a narrowing of the card-side shielding elements (35).

7. The connector system (100) according to one of claims 3 to 6,
wherein at least some (15) of the computer-side shielding elements (15, 16) have computer-side stop portions (15b) which limit a penetration of the card-side end portions (35a) of associated card-side shielding elements (35) into the computer-side connector element (10), and/or
wherein at least some (35) of the card-side shielding elements (35, 36) have card-side stop portions (35b) which limit a penetration of the computer-side end portions (15a) of associated computer-side shielding elements (15) into the card-side connector element (30).

8. The connector system (100) according to one of claims 3 to 7, wherein the computer-side connector element (10) is designed to be connected to the central computer along a first mounting direction (M1), wherein the card-side connector element (30) is designed to be connected to the PCB card along a second mounting direction (M2), and wherein the computer-side connector element (10) and the card-side connector element (30) can be plugged into each other along the first mounting direction (M1).

9. The connector system (100) according to one of claims 3 to 8,
wherein the computer-side connector element (10) has a plurality of computer-side differential-pair contact element pairs (13b), wherein each computer-side differential-pair contact element pair (13b) is arranged at least partially in one of the computer-side contact cavities (11b) formed by the computer-side shielding elements (15, 16), and
wherein the card-side connector element (30) has a plurality of card-side differential-pair contact element pairs (33b), wherein each card-side differential-pair contact element pair (33b) is arranged at least partially in one of the card-side contact cavities (31b) formed by the card-side shielding elements (15, 16).

10. The connector system (100) according to one of claims 3 to 9, wherein the computer-side end portions (15a, 16a) of the computer-side shielding elements (15, 16) and the card-side end portions (35a, 36a) of the card-side shielding elements (35, 36) have a basically identical length (L).

11. The connector system (100) according to claim 10 in conjunction with claim 9, wherein the length (L) is selected such that, when the computer-side connector element (10) and the card-side connector element (30) are plugged into each other, the computer-side end portions (15a, 16a) and the card-side end portions (35a, 36a) already overlap before the computer-side differential-pair contact element pairs (13b) and the card-side differential-pair contact element pairs (33b) completely contact each other.

12. The connector system (100) according to claim 10 or 11, wherein the card-side differential-pair contact elements (13b) have wave-shaped end portions in order to, when overlapping with a computer-side differential-pair contact element (33b), electrically contact the computer-side differential-pair contact element (33b) at at least two different contact points, and wherein the length (L) of the computer-side and/or card-side end portions is selected such that the card-side and computer-side differential-pair contact elements (13b, 33b) overlap in the mounted state such that they contact each other at the at least two provided contact points.

13. The connector system (100) according to one of claims 9 to 12,
wherein the computer-side differential-pair contact element pairs (13b) protrude beyond the computer-side shielding elements (15, 16), and/or
wherein the card-side shielding elements (35, 36) protrude beyond the card-side differential-pair contact element pairs (33b).

14. The connector system (100) according to one of claims 3 to 13, wherein the computer-side housing (2) and the card-side housing (40) are each produced by zinc die-casting.

## Revendications

1. Élément connecteur du côté du calculateur (10) destiné à un système de connecteur (100) servant à relier une carte de circuit imprimé à un calculateur central d'un véhicule à moteur, présentant un boîtier du côté du calculateur (20), lequel comporte de multiples éléments de blindage du côté du calculateur (15, 16), lesquels sont prévus et disposés pour former de multiples cavités de contact du côté du calculateur (31b) du boîtier du côté du calculateur (20), dans lequel les éléments de blindage du côté du calculateur (15, 16) comportent des parties terminales (15a, 16a), lesquelles sont prévues et disposées pour recouvrir respectivement les parties terminales associées (35a, 36a) des éléments de blindage du côté de la carte (35, 36) d'un élément connecteur du côté de la carte (10) à l'état monté ;
**caractérisé en ce que**
la totalité des éléments de blindage du côté du calculateur (15, 16) sont constitués d'un unique fragment du boîtier du côté du calculateur (20).

2. Élément connecteur du côté de la carte (30) destiné à un système de connecteur (100) servant à relier une carte de circuit imprimé à un calculateur central d'un véhicule à moteur, présentant un boîtier du côté de la carte (40), lequel comporte de multiples éléments de blindage du côté de la carte (35, 36), lesquels sont prévus et disposés pour former de multiples cavités de contact du côté de la carte (31b) du boîtier du côté de la carte (40), dans lequel les éléments de blindage du côté de la carte (35, 36) comportent des parties terminales (35a, 36a), lesquelles sont prévues et disposées pour recouvrir respectivement les parties terminales associées (15a, 16a) des éléments de blindage du côté du calculateur (15, 16) d'un élément connecteur du côté du calculateur (10) à l'état monté ;
**caractérisé en ce que**
la totalité des éléments de blindage du côté de la carte (35, 36) sont constitués d'un unique fragment du boîtier du côté de la carte (40).

3. Système de connecteur (100) servant à relier une carte de circuit imprimé à un calculateur central d'un véhicule à moteur, présentant un élément connecteur du côté du calculateur (10) selon la revendication 1 et un élément connecteur du côté de la carte (30) selon la revendication 2.

4. Système de connecteur (100) selon la revendication 3,
dans lequel les éléments de blindage du côté du calculateur (15, 16) sont conçus sous la forme d'éléments de limitation des cavités de contact du côté du calculateur (11b), et / ou
dans lequel les éléments de blindage du côté de la carte (35, 36) sont conçus sous la forme d'éléments de limitation des cavités de contact du côté de la carte (31b).

5. Système de connecteur (100) selon l'une des revendications 3 et 4, dans lequel les parties terminales (15a, 16a) des éléments de blindage du côté du calculateur (15, 16) et les parties terminales associées complémentaires (35a, 36a) des éléments de blindage du côté de la carte (35, 36) se recouvrent par complémentarité de forme à l'état monté.

6. Système de connecteur (100) selon la revendication 5, dans lequel au moins quelques-unes (15a) des parties terminales (15a, 16a) des éléments de blindage du côté du calculateur (15, 16) sont conçues respectivement sous la forme d'un rétrécissement des éléments de blindage du côté du calculateur (15), et / ou dans lequel au moins quelques-unes (35a) des parties terminales (35a, 36a) des éléments de blindage du côté de la carte (35, 36) sont conçues respectivement sous la forme d'un rétrécissement des éléments de blindage du côté de la carte (35).

7. Système de connecteur (100) selon l'une des revendications 3 à 6,
dans lequel au moins quelques-uns (15) des éléments de blindage du côté du calculateur (15, 16) présentent des parties de butée du côté du calculateur (15b),
lesquelles limitent une pénétration des parties terminales du côté de la carte (35a) des éléments de blindage du côté de la carte (35) respectivement associés dans l'élément connecteur du côté du calculateur (10), et / ou
dans lequel au moins quelques-uns (35) des éléments de blindage du côté de la carte (35, 36) présentent des parties de butée du côté de la carte (35b), lesquelles limitent une pénétration des parties terminales du côté du calculateur (15a) des éléments de blindage du côté du calculateur (15) respectivement associés dans l'élément connecteur du côté de la carte (30).

8. Système de connecteur (100) selon l'une des revendications 3 à 7, dans lequel l'élément connecteur du côté du calculateur (10) est conçu pour être relié au calculateur central suivant un premier sens de montage (M1), dans lequel l'élément connecteur du côté de la carte (30) est conçu pour être relié à la carte de circuit imprimé suivant un second sens de montage (M2), et dans lequel l'élément connecteur du côté du calculateur (10) et l'élément connecteur du côté de la carte (30) peuvent être assemblés suivant le premier sens de montage (M1).

9. Système de connecteur (100) selon l'une des revendications 3 à 8,
dans lequel l'élément connecteur du côté du calculateur (10) présente de multiples paires d'éléments de contact par paire différentielle (*differential pair*) du côté du calculateur (13b), dans lequel chaque paire d'éléments de contact par paire différentielle du côté du calculateur (13b) est disposée au moins par endroits dans l'une des cavités de contact du côté du calculateur (11b) formées par les éléments de blindage du côté du calculateur (15, 16), et
dans lequel l'élément connecteur du côté de la carte (30) présente de multiples paires d'éléments de contact par paire différentielle du côté de la carte (33b), dans lequel chaque paire d'éléments de contact par paire différentielle du côté de la carte (33b) est disposée au moins par endroits dans l'une des cavités de contact du côté de la carte (31b) formées par les éléments de blindage du côté de la carte (35, 36).

10. Système de connecteur (100) selon l'une des revendications 3 à 9, dans lequel les parties terminales du côté du calculateur (15a, 16a) des éléments de blindage du côté du calculateur (15, 16) et les parties terminales du côté de la carte (35a, 36a) des éléments de blindage du côté de la carte (35, 36) présentent une longueur (L) sensiblement égale.

11. Système de connecteur (100) selon la revendication 10 en relation avec la revendication 9, dans lequel la longueur (L) est choisie de telle manière que les parties terminales du côté du calculateur (15a, 16a) et les parties terminales du côté de la carte (35a, 36a) se recouvrent déjà lors d'un assemblage de l'élément connecteur du côté du calculateur (10) et de l'élément connecteur du côté de la carte (30) avant même que les paires d'éléments de contact par paire différentielle du côté du calculateur (13b) et les paires d'éléments de contact par paire différentielle du côté de la carte (33b) soient complètement en contact.

12. Système de connecteur (100) selon la revendication 10 ou 11, dans lequel les éléments de contact par paire différentielle du côté de la carte (13b) présentent des parties terminales ondulées pour établir un contact électrique avec l'élément de contact par paire différentielle du côté du calculateur (33b) en au moins deux points de contact différents lors d'un recouvrement avec un élément de contact par paire différentielle du côté du calculateur (33b), et dans lequel la longueur (L) des parties terminales du côté du calculateur et / ou du côté de la carte est choisie de telle manière que les éléments de contact par paire différentielle du côté du calculateur et du côté de la carte (13b, 33b) se recouvrent à l'état monté de telle façon qu'ils établissent un contact électrique au moins aux deux points de contact prévus.

13. Système de connecteur (100) selon l'une des revendications 9 à 12,
dans lequel les paires d'éléments de contact par paire différentielle du côté du calculateur (13b) dépassent les éléments de blindage du côté du calculateur (15, 16), et / ou
dans lequel les éléments de blindage du côté de la carte (35, 36) dépassent les paires d'éléments de contact par paire différentielle du côté de la carte (33b).

14. Système de connecteur (100) selon l'une des revendications 3 à 13, dans lequel le boîtier du côté du calculateur (20) et le boîtier du côté de la carte (40) sont fabriqués respectivement à base de zinc coulé sous pression.
